# EUROPEAN PATENT APPLICATION

(11) **EP 4 615 189 A1**
(43) Date of publication of application: **10.09.2025**
(21) Application number: 25151952.6
(22) Date of filing: 15.01.2025
(51) Int. Cl.: H10B 12/00

(54) **SEMICONDUCTOR MEMORY DEVICE**

(30) Priority: 05.03.2024 KR 20240031063
(71) Applicant: Samsung Electronics Co., Ltd., Suwon-si, Gyeonggi-do 16677 (KR)
(72) Inventor: CHANG, Ji Hoon, 16677 Suwon-si (KR); PARK, Chul Kwon, 16677 Suwon-si (KR); CHO, Seong Won, 16677 Suwon-si (KR); CHOI, Deok Hwan, 16677 Suwon-si (KR)
(74) Representative: Marks & Clerk LLP

(57) **Abstract**

A semiconductor memory device includes a bit line extending in a first direction, an active pattern on the bit line, and including first and second side walls opposite to each other in the first direction and first and second surfaces opposite to each other in a vertical direction, the first surface of the active pattern connected to the bit line, a word line on the first side wall of the active pattern and extending in a second direction, and a data storage pattern on the active pattern and connected to the second surface of the active pattern, wherein the word line includes first, second, third line patterns, and the second and third line patterns include conductive materials different from the first line pattern.

## Description

### BACKGROUND

### Technical Field

The present disclosure relates to semiconductor memory devices, and more specifically, to semiconductor memory devices including a vertical channel transistor (VCT).

### Description of the Related Art

It is required to increase the degree of integration of a semiconductor memory device so as to satisfy excellent performance and low price required by consumers. In the case of the semiconductor memory device, because the degree of integration is an important factor in determining the price of a product, an increased degree of integration is particularly required.

In the case of a two-dimensional or planar semiconductor memory device, the degree of integration is mainly determined by an area occupied by unit memory cells, and is therefore greatly affected by the level of a fine pattern formation technique. However, because ultra-expensive apparatuses are required to miniaturize the pattern, the degree of integration of the two-dimensional semiconductor memory device is increasing, but is still limited. Accordingly, semiconductor memory devices including vertical channel transistors whose channels extend in a vertical direction have been proposed.

### SUMMARY

Some example embodiments of the present disclosure provide semiconductor memory devices having improved degree of integration and electrical characteristics.

However, example embodiments of the present disclosure are not restricted to the one set forth herein. The above and other aspects of the present disclosure will become more apparent to one of ordinary skill in the art to which the present disclosure pertains by referencing the detailed description of the present disclosure given below.

According to an example embodiment of the present disclosure, a semiconductor memory device includes a bit line extending in a first direction on a substrate, an active pattern on the bit line, the active pattern including a first side wall and a second side wall that are opposite to each other in the first direction and a first surface and a second surface that are opposite to each other in a vertical direction, the first surface of the active pattern being connected to the bit line, a word line on the first side wall of the active pattern, the word line extending in a second direction and a data storage pattern on the active pattern, the data storage pattern connected to the second surface of the active pattern, wherein the word line includes a first line pattern including a first conductive material, a second line pattern including a second conductive material different from the first conductive material, and a third line pattern including a third conductive material different from the first conductive material, and the first line pattern is between the second line pattern and the third line pattern.

According to an example embodiment of the present disclosure, a semiconductor memory device includes a bit line extending in a first direction on a substrate, a word line on the bit line, the word line extending in a second direction, a back gate electrode on the bit line, the back gate electrode extending in the second direction, the back gate electrode being spaced apart from the word line in the first direction, an active pattern between the word line and the back gate electrode and a data storage pattern on the active pattern, the data storage pattern connected to the active pattern, wherein the word line includes a first line pattern and a second line pattern stacked in a vertical direction, the back gate electrode includes a first electrode pattern and a second electrode pattern stacked in the vertical direction, the first line pattern includes a conductive material different from the second line pattern, and the first electrode pattern includes a conductive material different from the second electrode pattern.

According to an example embodiment of the present disclosure, a semiconductor memory device includes a peri-gate structure on a substrate, a first bonding pad connected to the peri-gate structure, a second bonding pad on the first bonding pad, the second bonding pad being in contact with the first bonding pad, a bit line on the second bonding pad, the bit line extending in a first direction, a shielding conductive pattern including a plurality of shielding conductive line patterns on the second bonding pad, the shielding conductive pattern extending in the first direction to be adjacent to the bit line, a first word line on the bit line and the shielding conductive pattern, the first word line extending in a second direction, a second word line on the bit line and the shielding conductive pattern, the second word line extending in the second direction, the second word line being spaced apart from the first word line in the first direction, a back gate electrode between the first word line and the second word line, the back gate electrode extending in the second direction, a first active pattern on the bit line and between the first word line and the back gate electrode, a second active pattern on the bit line and between the first word line and the back gate electrode and a data storage pattern connected to the first active pattern and the second active pattern, wherein each of the first word line and the second word line includes a first line pattern including a first conductive material, a second line pattern including a second conductive material different from the first conductive material, and a third line pattern including a third conductive material different from the first conductive material.

At least some of the above and other features of the invention are set out in the claims. It should be noted that the effects of the present disclosure are not limited to those described above, and other effects of the present disclosure will be apparent from the following description.

### BRIFF DESCRIPTION OF DRAWINGS

FIG. 1 is a layout diagram for explaining a semiconductor memory device according to an example embodiment.
FIG. 2 is a cross-sectional view taken along lines A-A and B-B of FIG. 1.
FIG. 3 is a cross-sectional view taken along lines C-C and D-D of FIG. 1.
FIG. 4 is an enlarged view of a portion P of FIG. 2.
FIGS. 5 and 6 are enlarged views showing a third line pattern of FIG. 4.
FIGS. 7 and 8 are diagrams for explaining a semiconductor memory device according to some example embodiments.
FIGS. 9 to 12 are diagrams for explaining a semiconductor memory device according to an example embodiment.
FIGS. 13 and 14 are diagrams for explaining a semiconductor memory device according to some example embodiments, respectively.
FIGS. 15 to 17 are diagrams for explaining a semiconductor memory device according to an example embodiment.
FIGS. 18 and 19 are diagrams for explaining the semiconductor memory device according to an example embodiment.
FIGS. 20 and 21 are diagrams for explaining a semiconductor memory device according to an example embodiment.
FIGS. 22 and 23 are diagrams for explaining the semiconductor memory device according to an example embodiment.
FIGS. 24 to 27 are diagrams for explaining a semiconductor memory device according to some example embodiments, respectively.
FIGS. 28 to 62 are intermediate stage diagrams for explaining a method for fabricating a semiconductor memory device according to an example embodiment.

### DETAILED DESCRIPTION

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B. As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

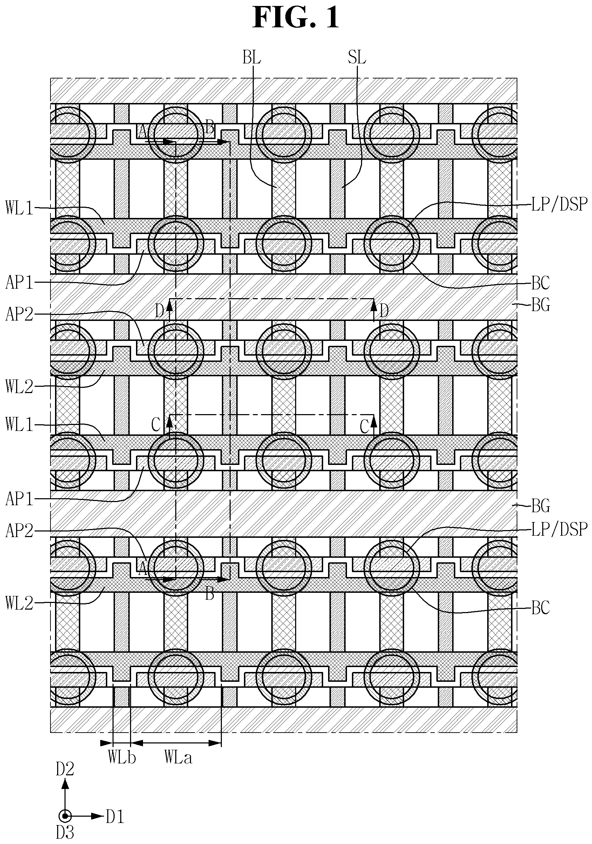

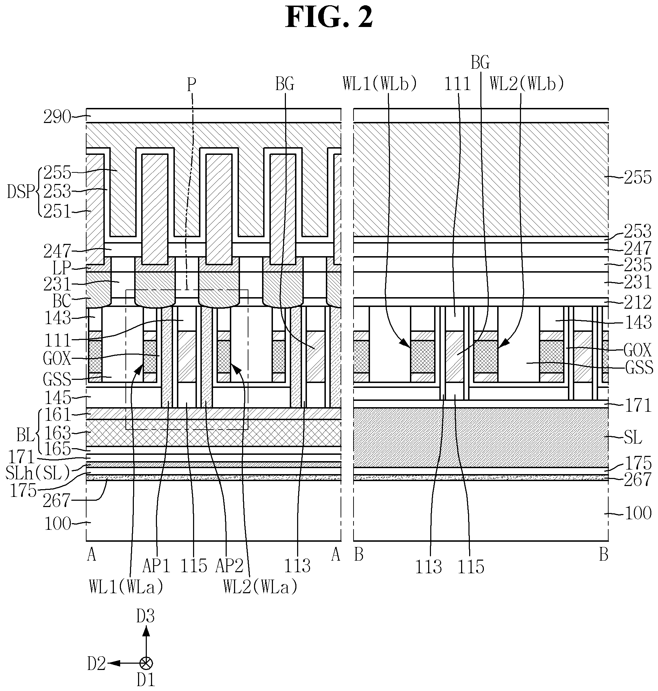

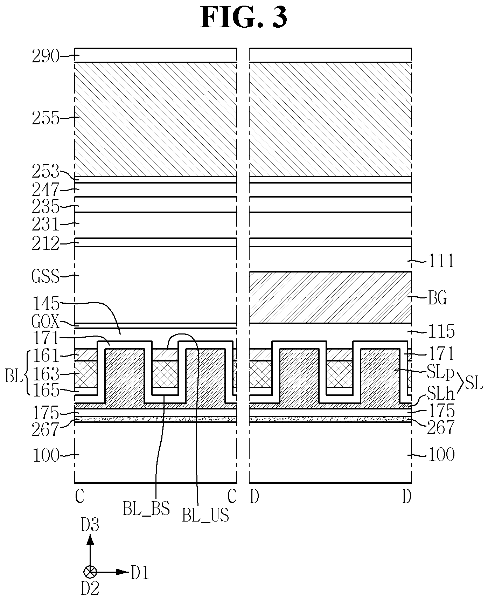

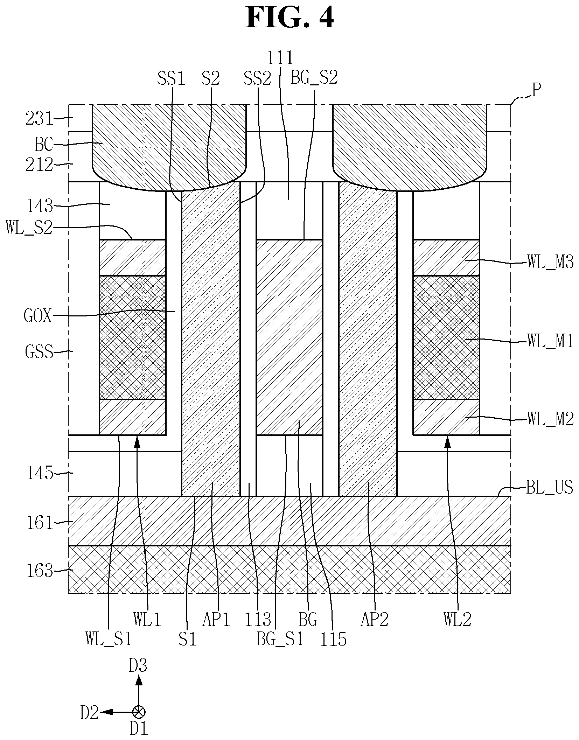

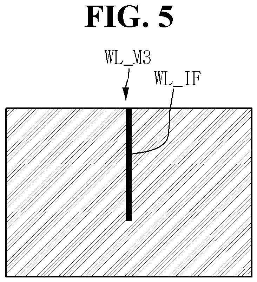

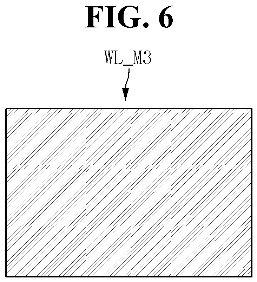

FIG. 1 is a layout diagram for explaining a semiconductor memory device according to an example embodiment. FIG. 2 is a cross-sectional view taken along lines A-A and B-B of FIG. 1. FIG. 3 is a cross-sectional view taken along lines C-C and D-D of FIG. 1. FIG. 4 is an enlarged view of a portion P of FIG. 2. FIGS. 5 and 6 are enlarged views showing a third line pattern of FIG. 4.

The semiconductor memory device according to an example embodiment of the present disclosure may include a memory cell including a vertical channel transistor (VCT).

Referring to FIGS. 1 to 7, the semiconductor memory device according to an example embodiment may include bit lines BL, word lines WL1 and WL2, back gate electrodes BG, a shielding conductive pattern SL, active patterns AP1 and AP2, and data storage patterns DSP.

The substrate 100 may be a silicon substrate or may include other materials, for example, but not limited to, silicon germanium, indium antimonide, lead telluride, indium arsenide, indium phosphide, gallium arsenide or gallium antimonide.

Although not shown, the substrate 100 may include a cell array region in which the data storage pattern is disposed, and a peripheral circuit region defined around the cell array region.

A bonding insulating film 267 may be disposed on the substrate 100. The bonding insulating film 267 may be used to bond a wafer. As an example, the bonding insulating film 267 may include silicon carbonitride (SiCN). As another example, the bonding insulating film 267 may include silicon oxide (SiO₂).

Shielding structures 171, SL, and 175 may be disposed on the substrate 100. For example, the shielding structures 171, SL, and 175 may be disposed on the bonding insulating film 267.

The shielding structures 171, SL, and 175 may include a shielding conductive pattern SL and shielding insulating films 171 and 175. For example, the shielding insulating films 171 and 175 may include a shielding insulating liner 171 and a shielding insulating capping film 175.

The shielding conductive pattern SL may include a shielding conductive plate SLh and a plurality of shielding conductive line patterns SLp. The shielding conductive plate SLh may have a flat plate shape.

Each shielding conductive line pattern SLp may extend in a second direction D2. Each shielding conductive line pattern SLp may be adjacent to each other in a first direction D1. The shielding conductive line pattern SLp may protrude from the shielding conductive plate SLh in a third direction D3. The shielding conductive line pattern SLp is directly connected to the shielding conductive plate SLh.

For example, the first direction D1 and the second direction D2 may be horizontal directions that are horizontal to the substrate 100. The third direction D3 may be a vertical direction that is perpendicular to the substrate 100. For instance, a top surface of the substrate 100 may extend in the first direction D1 and the second direction D2. The first direction D1 may cross the second direction D2 (e.g. may be perpendicular, or at least non-parallel, to the second direction D2). The top surface of the substrate 100 may define a horizontal direction of the semiconductor memory device. The third direction D3 (e.g. a vertical direction) may be perpendicular to the top surface of the substrate 100 (e.g. perpendicular to the first direction D1 and the second direction D2). Relative positional terms, such as "upper", "lower", "above", "below", etc. may be defined relative to the third direction D3. For instance, the terms "upper", "middle", "lower" may refer to relative positions along the third direction D3. It will be appreciated that these relative terms and these directions are defined relative to the structure of the semiconductor memory device, and therefore need not limit the orientation of the semiconductor memory device in use.

The shielding conductive plate SLh and each shielding conductive line pattern SLp may extend from the cell array region to the peripheral circuit region. A part of the shielding conductive pattern SL may be disposed on the peripheral circuit region, but example embodiments are not limited thereto.

The shielding conductive pattern SL includes a conductive material. The shielding conductive pattern SL may include, for example, at least one of conductive metal nitride, conductive metal silicon nitride, metal carbonitride, conductive metal silicide, conductive metal oxide, a two-dimensional material, or metal.

A shielding insulating capping film 175 may be disposed on the substrate 100. For example, the shielding insulating capping film 175 may be disposed between the substrate 100 and the shielding conductive pattern SL.

The shielding insulating capping film 175 may be in contact with the shielding conductive pattern SL. In the semiconductor memory device according to some example embodiments, the shielding insulating capping film 175 may be in contact with the shielding conductive plate SLh.

A shielding insulating liner 171 may be disposed on the shielding conductive pattern SL. The shielding insulating liner 171 may be disposed between the bit line BL and the substrate 100. The shielding insulating liner 171 may extend along the profiles of the shielding conductive plate SLh and the shielding conductive line pattern SLp.

The shielding insulating liner 171 and the shielding insulating capping film 175 may each be formed of an insulating material. When the shielding insulating liner 171 and the shielding insulating capping film 175 include the same material, a boundary between the shielding insulating liner 171 and the shielding insulating capping film 175 may not be distinguished.

Because the shielding structures 171, SL, and 175 are disposed between the bit lines BL adjacent in the first direction D1, a coupling noise between the bit lines BL may be reduced.

The bit lines BL may be disposed on the substrate 100. For example, the bit lines BL may be disposed on the bonding insulating film 267.

Each bit line BL may extend in the second direction D2. For instance, the bit lines BL may extend long in the second direction D2. Adjacent bit lines BL may be spaced apart in the first direction D1. Each bit line BL includes a first side wall (e.g. a long side wall) extending in the second direction D2, and a second side wall (e.g. a short side wall) extending in the first direction D1. The first side wall may be longer than the second side wall.

The bit line BL may be disposed on the shielding conductive pattern SL. The bit line BL may be disposed on the shielding conductive plate SLh.

The bit line BL may be disposed adjacent to the shielding conductive line pattern SLp. The bit line BL may be disposed adjacent to the shielding conductive line pattern SLp in the first direction D1. In other words, the shielding conductive line pattern SLp may extend in the second direction D2 along the first side wall of the bit line BL.

The bit line BL may be disposed between the shielding conductive line patterns SLp adjacent in the first direction D1. The bit line BL may be disposed on the shielding insulating liner 171. For example, the shielding insulating liner 171 may be in contact with the bit line BL.

Although not shown, each bit line BL may extend from the cell array region to the peripheral circuit region. A part of each bit line BL may be disposed on the peripheral circuit region.

The bit line BL may include an upper surface BL_US and a bottom surface BL_BS that are opposite to each other in the third direction D3. The upper surface BL_US of the bit line may look at (e.g. may face) a first active pattern AP1 and a second active pattern AP2, which will be described below. As described herein, one surface that "looks at" a particular component or feature may be alternatively referred to as "facing" that component or feature.

In the semiconductor memory device according to some embodiments, the shielding conductive pattern SL may be disposed on the bottom surface BL_BS of the bit line. For example, the shielding conductive plate SLh may be disposed on the bottom surface BL_BS of the bit line.

Each bit line BL may include a semiconductor pattern 161, a metal pattern 163, and a bit line mask pattern 165 that are stacked in this order (e.g. from top to bottom). The metal pattern 163 may be located between the semiconductor pattern 161 and the bit line mask pattern 165. The semiconductor pattern 161 may be located between the metal pattern 163 (e.g. blow the metal pattern 163) and the shielding insulating liner 171 (e.g. above the shielding insulating liner 171). In some example embodiments, the bit line BL may include one of a semiconductor pattern 161 or a metal pattern 163. In some other example embodiments, the bit line BL may not include the bit line mask pattern 165.

The bit line BL may include a conductive bit line. The conductive bit line includes a film made of a conductive material among the bit lines BL. The conductive bit line may include a semiconductor pattern 161 and a metal pattern 163.

The semiconductor pattern 161 may include a conductive semiconductor material. The conductive semiconductor material may be, for example, a semiconductor material doped with impurities. The semiconductor pattern 161 may include at least one of poly silicon, poly silicon germanium, poly germanium, amorphous silicon, amorphous silicon germanium, or amorphous germanium.

The metal pattern 163 may include a conductive material including metal. The metal pattern 163 may include, for example, at least one of conductive metal nitride, conductive metal silicon nitride, metal carbonitride, conductive metal silicide, conductive metal oxide, a two-dimensional material, or metal. In the semiconductor memory device according to some example embodiments, the two-dimensional material may be a metallic material and/or a semiconductor material. The two-dimensional material may include a 2D allotrope or a 2D compound, and may include, but not limited to, at least one of graphene, molybdenum disulfide (MoS₂), molybdenum diselenide (MoSe₂), tungsten diselenide (WSe₂), or tungsten disulfide (WS₂). That is, because the above-mentioned two-dimensional materials are only listed as an example, the two-dimensional materials that may be included in the semiconductor memory device of the present disclosure are not limited by the above-mentioned materials.

The bit line mask pattern 165 may include an insulating material. The bit line mask pattern 165 may include, but not limited to, silicon nitride or silicon oxynitride.

The first active patterns AP1 and the second active patterns AP2 may be disposed on each bit line BL. The first active patterns AP1 and the second active patterns AP2 may be alternately disposed along the second direction D2.

The first active patterns AP1 may be spaced apart from each other in the first direction D1. The first active patterns AP1 may be spaced apart at regular intervals. The second active patterns AP2 may be spaced apart from each other in the first direction D1. The second active patterns AP2 may be spaced apart at regular intervals. The first active patterns AP1 may be spaced apart from the second active patterns AP2 in the second direction D2. The first active patterns AP1 and the second active patterns AP2 may be arranged two-dimensionally along the first direction D1 and the second direction D2 that intersect each other. For instance, multiple rows of first active patterns AP1 and second active patterns AP2 may be arranged, each row running parallel to the first direction D1, and spaced apart from the other rows in the second direction D2.

For example, the first active pattern AP1 and the second active pattern AP2 may each be made of or include a single crystal semiconductor material. For example, the first active pattern AP1 and the second active pattern AP2 may each be made of or include single crystal silicon.

The first active pattern AP1 and the second active pattern AP2 each have a length in the first direction D1, a width in the second direction D2, and a height in the third direction D3. Each of the first active pattern AP1 and the second active pattern AP2 may have a substantially uniform width. That is, each of the first active pattern AP1 and the second active pattern AP2 may have substantially the same width on first and second surfaces S1 and S2 of the first active pattern AP1. Further, the width of the first active pattern AP1 may be equal to the width of the second active pattern AP2.

A width of the first active pattern AP1 and a width of the second active pattern AP2 may range from several nm to several tens of nm. For example, the width of the first active pattern AP1 and the width of the second active pattern AP2 may be, but not limited to, 1 nm to 30 nm (e.g. about 1 nm to about 30 nm), more specifically, 1 nm to 10 nm (e.g. about 1 nm to about 10 nm). A length of each of the first and second active patterns AP1 and AP2 may be greater than a line width of the bit line BL. That is, the length of each of the first and second active patterns AP1 and AP2 in the first direction D1 may be greater than the width of the bit line BL in the first direction D1.

As shown in FIG. 4, each of the first active pattern AP1 and the second active pattern AP2 includes a first surface S1 and a second surface S2 that are opposite to each other in the third direction D3. For example, the first surfaces S1 of the first and second active patterns AP1 and AP2 may look at (e.g. may face) the bit line BL. The second surfaces S2 of the first and second active patterns AP1 and AP2 may look at (e.g. may face) the contact pattern BC.

The first surfaces S1 of the first and second active patterns AP1 and AP2 are connected to the bit line BL. For example, the first surfaces S1 of the first and second active patterns AP1 and AP2 may be connected to the semiconductor pattern 161 of the bit line BL. In some example embodiments, when the semiconductor pattern 161 is omitted, the first surfaces S1 of the first and second active patterns AP1 and AP2 may be connected to the metal pattern 163. The second surfaces S2 of the first and second active patterns AP1 and AP2 may be connected to the contact patterns BC.

Each of the first active pattern AP1 and the second active pattern AP2 may include a first side wall SS1 and a second side wall SS2 that are opposite to each other in the second direction D2. The second side wall SS2 of the first active pattern AP1 may face the first side wall SS1 of the second active pattern AP2.

The first side wall SS1 of the first active pattern AP1 may be adjacent to the first word line WL1. The second side wall SS2 of the second active pattern AP2 may be adjacent to the second word line WL2.

Although not shown, as an example, each of the first and second active patterns AP1 and AP2 may include a first dopant region adjacent to the bit line BL, and a second dopant region adjacent to the contact pattern BC. Each of the first active pattern AP1 and the second active pattern AP2 may include a channel region between the first dopant region and the second dopant region. The first dopant region and the second dopant region are regions in which a dopant is doped in the first active pattern AP1 and the second active pattern AP2. In some example embodiments, each of the first active pattern AP1 and the second active pattern AP2 may not include at least one of the first dopant region or the second dopant region.

At the time of operation of the semiconductor memory device, the channel regions of the first and second active patterns AP1 and AP2 may be controlled by the first and second word lines WL1 and WL2 and the back gate electrodes BG. Because the first and second active patterns AP1 and AP2 are made of a single crystal semiconductor material, leakage current characteristics of the semiconductor memory device may be improved.

The back gate electrodes BG may be disposed on the bit line BL and the shielding conductive pattern SL. The back gate electrodes BG may be spaced apart from each other in the second direction D2. The back gate electrodes BG may be spaced apart at regular intervals. Each back gate electrode BG may extend in the first direction D1 across the bit line BL.

Each back gate electrode BG may be disposed between the first active pattern AP1 and the second active pattern AP2 that are adjacent to each other in the second direction D2. That is to say, the first active pattern AP1 may be disposed on one side of each back gate electrode BG, and the second active pattern AP2 may be disposed on the other side of each back gate electrode BG. A height of the back gate electrode BG in the third direction D3 may be smaller than heights of the first and second active patterns AP1 and AP2.

Each back gate electrode BG may be disposed between the second side wall SS2 of the first active pattern AP1 and the first side wall SS1 of the second active pattern AP2. Each back gate electrode BG may be disposed on the second side wall SS2 of the first active pattern AP1 and the first side wall SS1 of the second active pattern AP2.

The first active pattern AP1 may be disposed between the first word line WL1 and the back gate electrode BG. The second active pattern AP2 may be disposed between the second word line WL2 and the back gate electrode BG. A pair including a first word line WL1 and a second word line WL2 may be disposed between the back gate electrodes BG adjacent to each other in the second direction D2.

The back gate electrode BG may include a first surface BG_S1 and a second surface BG_S2 that are opposite to each other in the third direction D3. The first surface BG_S1 of the back gate electrode is closer to the bit line BL than the second surface BG_S2 of the back gate electrode. The first surface BG_S1 of the back gate electrode may look at (e.g. may face) the bit line BL.

The back gate electrode BG includes a conductive material, and may include, for example, at least one of a conductive semiconductor material, conductive metal nitride, conductive metal silicon nitride, metal carbonitride, conductive metal silicide, conductive metal oxide, a two-dimensional material, or metal.

A voltage is applied to the back gate electrode BG at the time of operation of the semiconductor memory device, and a threshold voltage of the vertical channel transistor may be adjusted. Because the threshold voltage of the vertical channel transistor is adjusted, the leakage current characteristics may be mitigated or prevented from deteriorating.

A back gate separation pattern 111 may be disposed between the first active pattern AP1 and the second active pattern AP2 that are adjacent to each other in the second direction D2. The back gate separation pattern 111 may extend in the first direction D1 along with the back gate electrode BG. The back gate separation pattern 111 may be disposed on the second surface BG_S2 of the back gate electrode.

The back gate separation pattern 111 may be formed of an insulating material. The back gate separation pattern 111 may include, for example, but not limited to, a silicon oxide film, a silicon oxynitride film or a silicon nitride film.

A back gate insulating pattern 113 may be disposed between the back gate electrode BG and the first active pattern AP1, and between the back gate electrode BG and the second active pattern AP2. The back gate insulating pattern 113 may be disposed between the back gate separation pattern 111 and the first active pattern AP1, and between the back gate separation pattern 111 and the second active pattern AP2.

The back gate insulating pattern 113 may be formed of an insulating material. The back gate insulating pattern 113 may include, for example, a silicon oxide film, a silicon oxynitride film, a high dielectric constant insulating film having a higher dielectric constant than a silicon oxide film, or a combination thereof.

A back gate capping pattern 115 may be disposed between the bit line BL and the back gate electrode BG. The back gate capping pattern 115 may be disposed between the first active pattern AP1 and the second active pattern AP2 that are adjacent to each other in the second direction D2. The back gate capping pattern 115 may extend in the first direction D1 along with the back gate electrode BG. The back gate capping pattern 115 may be disposed on the first surface BG_S1 of the back gate electrode. A thickness of the back gate capping pattern 115 between the bit lines BL may be different from the thickness of the back gate capping pattern 115 on the bit line BL, but is not limited thereto.

The back gate capping pattern 115 may be formed of an insulating material. The back gate capping pattern 115 may include, for example, but not limited to, at least one of a silicon oxide film, a silicon oxynitride film, and a silicon nitride film.

The first word line WL1 and the second word line WL2 may be disposed on the bit line BL and the shielding conductive pattern SL. Each of the first word line WL1 and the second word line WL2 may extend in the first direction D1. The first word lines WL1 and the second word line WL2 may be alternately arranged in the second direction D2.

The first word line WL1 may be disposed on the first side wall SS1 of the first active patterns AP1. The second word line WL2 may be disposed on the second side wall SS2 of the second active patterns AP2. The first active patterns AP1 and the second active patterns AP2 may be disposed between the first word line WL1 and the second word line WL2 adjacent to each other in the second direction D2.

The first word line WL1 and the second word line WL2 may be spaced apart from the bit line BL and the contact pattern BC in the third direction D3. The first word line WL1 and the second word line WL2 may be located between the bit line BL and the contact pattern BC.

Each of the first word line WL1 and the second word line WL2 may have a width in the second direction D2. As an example, the width of the first word line WL1 and the width of the second word line WL2 on the bit line BL may be different from the width of the first word line WL1 and the width of the second word line WL2 on the shielding conductive pattern SL.

For example, each of the first word line WL1 and the second word line WL2 may include one or more first portions WLa of the word line and one or more second portions WLb of the word line. A width of the first portion WLa of the word line in the second direction D2 may be smaller than a width of the second portion WLb of the word line in the second direction D2. As an example, the first portion WLa of the word line may be disposed on the bit line BL. The second portion WLb of the word line may be disposed on the shielding conductive line SL.

Each of the first word line WL1 and the second word line WL2 may include the first portion WLa of the word line and the second portion WLb of the word line that are alternately disposed along the first direction D1. For instance, first and second portions WLa and WLb may be alternately disposed down the length of each word line. On the first word line WL1, each first active pattern AP1 may be disposed between the second portions WLb of the word lines adjacent in the first direction D1. On the second word line WL2, each second active pattern AP2 may be disposed between the second portions WLb of the word lines adjacent in the first direction D1.

In some example embodiments, the width of the first portion WLa of the word line in the second direction D2 may be identical to the width of the second portion WLb of the word line in the second direction D2. In other words, the width of the first word line WL1 and the width of the second word line WL2 on the bit line BL may be identical to the width of the first word line WL1 and the width of the second word line WL2 on the shielding conductive line SL, respectively. A gate insulating pattern GOX, which will be described below, may fill a space between the first active patterns AP1 adjacent to each other in the first direction D1 and a space between the second active patterns AP2 adjacent to each other in the first direction D1.

The first word line WL1 and the second word line WL2 may include a first surface WL_S1 and a second surface WL_S2 that are opposite to each other in the third direction D3. The first surfaces WL_S1 of the first and second word lines are closer to the bit line BL than the second sides WL_S2 of the first and second word lines. The first surfaces WL_S1 of the first and second word lines looks at (e.g. faces) the bit line BL.

The first word line WL1 will be explained as an example; however, it will be appreciated that the second word line WL2 may be similarly arranged. As an example, a height of the first word line WL1 in the third direction D3 may be identical to a height of the back gate electrode BG in the third direction D3. As another example, the height of the first word line WL1 in the third direction D3 may be greater than the height of the back gate electrode BG in the third direction D3. As yet another example, the height of the first word line WL1 in the third direction D3 may be smaller than the height of the back gate electrode BG in the third direction D3.

Furthermore, as an example, the height of the first surface WL_S1 of the first word line may be identical to the height of the first surface BG_S1 of the back gate electrode, on the basis of (e.g. relative to) the upper surface of the bit line BL_US. As another example, the first surface WL_S1 of the first word line may be higher than the first surface BG_S1 of the back gate electrode. As yet another example, the first surface WL_S1 of the first word line may be lower than the first surface BG_S1 of the back gate electrode.

In addition, as an example, the height of the second surface WL_S2 of the first word line may be identical to the height of the second surface BG_S2 of the back gate electrode, on the basis of (e.g. relative to) the upper side of the bit line BL. As another example, the second surface WL_S2 of the first word line may be higher than the second surface BG_S2 of the back gate electrode. As yet another example, the second surface WL_S2 of the first word line may be lower than the second surface BG_S2 of the back gate electrode.

The first surfaces WL_S1 of the first and second word lines WL1 and WL2 may be, but not limited to, a plane. The second surfaces WL_S2 of the first and second word lines WL1 and WL2 may be, but not limited to, a plane. Although the first surface BG_S1 of the back gate electrode and the second surface BG_S2 of the back gate electrode are shown as a plane, but are not limited thereto.

Each of the first word line WL1 and the second word line WL2 may include a first line pattern WL_M1, a second line pattern WL_M2, and a third line pattern WL_M3. The first line pattern WL_M1, the second line pattern WL_M2, and the third line pattern WL_M3 may be stacked in the third direction D3. For example, the first line pattern WL_M1 may be disposed between the second line pattern WL_M2 and the third line pattern WL_M3.

The second line pattern WL_M2 may include a first surface WL_S1 of the respective wordline (e.g. one of the first and second word lines WL1 and WL2). The third line pattern WL_M3 may include a second surface WL_S2 of the respective wordline (e.g. one of the first and second word lines WL1 and WL2). In the semiconductor memory device according to some example embodiments, the first line pattern WL_M1 may be in contact with the second line pattern WL_M2 and the third line pattern WL_M3.

The first line pattern WL_M1 may include a first conductive material. The second line pattern WL_M2 may include a second conductive material different from the first conductive material. The third line pattern WL_M3 may include a third conductive material different from the first conductive material.

A work function of the first conductive material is different from a work function of the second conductive material. The work function of the first conductive material is different from a work function of the third conductive material.

As an example, the second conductive material included in the second line pattern WL_M2 may be the same as (e.g. identical to) the third conductive material included in the third line pattern WL_M3. As another example, the second conductive material included in the second line pattern WL_M2 may be different from the third conductive material included in the third line pattern WL_M3.

The first word line WL1 and the second word line WL2 may include a conductive material. The first word line WL1 and the second word line WL2 may include, for example, at least one of a conductive semiconductor material, conductive metal nitride, conductive metal silicon nitride, conductive metal carbonitride, conductive metal silicide, conductive metal oxide, a two-dimensional material, or a metal.

Each of the first line pattern WL_M1, the second line pattern WL_M2, and the third line pattern WL_M3 may include, for example, at least one of a conductive semiconductor material, conductive metal nitride, conductive metal silicon nitride, conductive metal carbonitride, conductive metal silicide, conductive metal oxide, a two-dimensional material, or metal.

At least one of the first line pattern WL_M1, the second line pattern WL_M2, and the third line pattern WL_M3 may include a line internal interface WL_IF. The third line pattern WL_M3 will be explained as an example; however, it will be appreciated that the first line pattern WL_M1 and/or the second line pattern WL_M2 may be similarly arranged.

As shown in FIGS. 4 and 5, the third line pattern WL_M3 may include the line internal interface WL_IF. The line internal surface may define an interface (e.g. a break or discontinuity in the structure of the third line pattern WL_M3). The line internal interface WL_IF may extend in the third direction D3. In other words, the line internal interface WL_IF may extend in the vertical direction. The line internal interface WL_IF may extend up to the second surface WL_S2 of the respective wordline (e.g. one of the first and second word lines WL1 and WL2). The line internal interface WL_IF may not extend up to a boundary between the first line pattern WL_M1 and the third line pattern WL_M3. In some example embodiments, the line internal interface WL_IF may extend up to the boundary between the first line pattern WL_M1 and the third line pattern WL_M3. For example, the line internal interface WL_IF may be formed in the process of depositing the third line pattern WL_M3.

As shown in FIGS. 4 and 6, the third line pattern WL_M3 may not include the line internal interface (WL_IF of FIG. 5).

It goes without saying that the explanation about the third line pattern WL_M3 may be applied to the first line pattern WL_M1 and the second line pattern WL_M2.

Because the first word line WL1 and the second word line WL2 have different materials from each other to form a multiple film structure, gate induced drain leakage (GIDL) characteristics of the vertical channel transistor may be improved.

The gate insulating patterns GOX may be disposed between the first word line WL1 and the first active pattern AP1, and between the second word line WL2 and the second active pattern AP2. The gate insulating pattern GOX may extend in the first direction D1 along with the first word line WL1 and the second word line WL2.

The gate insulating pattern GOX may include a silicon oxide film, a silicon oxynitride film, a high dielectric constant insulating film having a higher dielectric constant than a silicon oxide film or a combination thereof. The high dielectric constant insulating film may include, for example, but not limited to, at least one of metal oxide, metal oxynitride, metal silicon oxide, or metal silicon oxynitride.

The gate insulating pattern GOX may extend along the first side wall SS1 of the first active pattern AP1, and may extend along the second side wall SS2 of the second active pattern AP2. The gate insulating pattern GOX may be disposed between the first active pattern AP1 and the gate capping pattern 143, and between the second active pattern AP2 and the gate capping pattern 143. The gate insulating pattern GOX may be disposed between the first active pattern AP1 and the gate shielding pattern 145, and between the second active pattern AP2 and the gate shielding pattern 145.

In the semiconductor memory device according to some example embodiments, the gate insulating pattern GOX may not be disposed between the first active pattern AP1 and the gate shielding pattern 145, and between the second active pattern AP2 and the gate shielding pattern 145.

From the viewpoint of the cross-sectional view, the gate insulating pattern GOX between the first active pattern AP1 and the first word line WL1 may be connected to the gate insulating pattern GOX between the second active pattern AP2 and the second word line WL2. In some example embodiments, the gate insulating pattern GOX between the first active pattern AP1 and the first word line WL1 may be separated from the gate insulating pattern GOX between the second active pattern AP2 and the second word line WL2.

The gate capping pattern 143 may be disposed between the first word line WL1 and the contact pattern BC, and between the second word line WL2 and the contact pattern BC. The gate capping pattern 143 may cover the second surfaces WL_S2 of the first and second word lines WL1 and WL2.

From the viewpoint of the cross-sectional view, the gate capping pattern 143 between the first word line WL1 and the contact pattern BC may be spaced apart from the gate capping pattern 143 between the second word line WL2 and the contact pattern BC in the second direction D2. The gate capping pattern 143 between the first word line WL1 and the contact pattern BC may be separated from the gate capping pattern 143 between the second word line WL2 and the contact pattern BC, by the gate separation patterns GSS.

The gate shielding pattern 145 may be disposed between the first word line WL1 and the bit line BL, and between the second word line WL2 and the bit line BL. The gate shielding pattern 145 may be disposed on the first surfaces WL_S1 of the first and second word lines WL1 and WL2.

The gate shielding pattern 145 may include an upper surface and a bottom surface that are opposite to each other in the third direction D3. The bottom surface of the gate shielding pattern 145 may look at (e.g. may face) the bit line BL. The first word line WL1 and the second word line WL2 may be disposed on the upper surface of the gate shielding pattern 145. The gate insulating pattern GOX may extend along the upper surface of the gate shielding pattern 145.

Each of the gate capping pattern 143 and the gate shielding pattern 145 may be formed of an insulating material. The gate capping pattern 143 and the gate shielding pattern 145 may each include, for example, but not limited to, one of a silicon oxide film, a silicon oxynitride film, or a silicon nitride film.

The gate separation pattern GSS may be disposed on the bit line BL. The gate separation pattern GSS may be disposed on the gate shielding pattern 145. For example, the gate separation pattern GSS may be disposed on the upper surface of the gate shielding pattern 145.

The gate separation pattern GSS may be disposed between the first word line WL1 and the second word line WL2 that are adjacent to each other in the second direction D2. The first word line WL1 and the second word line WL2 may be separated by the gate separation pattern GSS. The gate separation pattern GSS may extend in the first direction D1 between the first word line WL1 and the second word line WL2.

The first word line WL1 may be disposed between the gate separation pattern GSS and the first active pattern AP1. The gate separation pattern GSS may be disposed on the first side wall SS1 of the first active pattern AP1. The second word line WL2 may be disposed between the gate separation pattern GSS and the second active pattern AP2. The gate separation pattern GSS may be disposed on the second side wall SS2 of the second active pattern AP2.

The gate capping pattern 143 may be disposed between the gate separation pattern GSS and the first active pattern AP1. The gate capping pattern 143 may be disposed between the gate separation pattern GSS and the second active pattern AP2.

The gate separation pattern GSS may be formed of an insulating material. In some example embodiments, the gate separation pattern GSS may include a plurality of insulating films.

The contact patterns BC may penetrate a contact interlayer insulating film 231 and a contact etching stop film 212. The contact patterns BC may be connected to each of the first active pattern AP1 and the second active pattern AP2. The contact patterns BC may be connected to the second surfaces S2 of the first and second active patterns AP1 and AP2. From the viewpoint of a plan view, each contact pattern BC may have various shapes such as a circle, an ellipse, a rectangle, a square, a rhombus, and a hexagon.

The contact pattern BC may include a conductive material. The contact pattern BC may include, for example, at least one of doped polysilicon, conductive metal nitride, conductive metal silicon nitride, metal carbonitride, conductive metal silicide, conductive metal oxide, a two-dimensional material, or metal

The contact etching stop film 212 may be disposed on the gate capping pattern 143 and the back gate separation pattern 111. Each of the contact interlayer insulating film 231 and the contact etching stop film 212 may be formed of an insulating material.

Landing pads LP may be disposed on the contact pattern BC. From the viewpoint of a plan view, the landing pads LP may have various shapes such as a circle, an ellipse, a rectangle, a square, a rhombus, and a hexagon.

Pad separation insulating patterns 235 may be disposed between the landing pads LP. From the viewpoint of a plan view, the landing pads LP may be arranged in the form of a matrix along the first direction D1 and the second direction D2. The upper surface of the landing pad LP may be, but not limited to, substantially coplanar with the upper surface of the pad separation insulating pattern 235.

The landing pads LP include conductive materials, and may include, for example, at least one of doped polysilicon, conductive metal nitride, conductive metal silicon nitride, metal carbonitride, conductive metal silicide, conductive metal oxide, a 2D material or metal.

Data storage patterns DSP may be disposed on the landing pads LP, respectively. The data storage patterns DSP may be electrically connected to the first and second active patterns AP1 and AP2, respectively. The data storage patterns DSP may be arranged in the form of a matrix along the first direction D1 and the second direction D2, as shown in FIG. 1. The data storage patterns DSP may completely or partially overlap the landing pads LP in the third direction D3. The data storage patterns DSP may be in contact with all or part of the upper surface of the landing pad LP.

As an example, the data storage patterns DSP may be capacitors. The data storage patterns DSP may include a capacitor dielectric film 253 interposed between the storage electrodes 251 and the plate electrode 255. For example, the storage electrode 251 may be in contact with the landing pad LP. From the viewpoint of a plan view, the storage electrode 251 may have various shapes such as a circle, an ellipse, a rectangle, a square, a rhombus, and a hexagon

The data storage patterns DSP may be in contact with all or part of the upper surface of the landing pad LP. The storage electrodes 251 may penetrate the upper etching stop film 247. The upper etching stop film 247 may be formed of an insulating material. Although a part of the storage electrode 251 is shown to enter the landing pad LP, example embodiments are not limited thereto.

Each of the storage electrode 251 and the plate electrode 255 may include, for example, at least one of a conductive semiconductor material, conductive metal nitride, conductive metal silicon nitride, metal carbonitride, conductive metal silicide, conductive metal oxide, or metal. The capacitor dielectric film 253 may include at least one of a ferroelectric material, an antiferroelectric material, or a paraelectric material. For example, the capacitor dielectric film 253 may include one of the ferroelectric material, the antiferroelectric material, the paraelectric material, a combination of the ferroelectric and antiferroelectric materials, a combination of the ferroelectric and paraelectric materials, a combination of paraelectric and antiferroelectric materials, and a combination of the ferroelectric material, the antiferroelectric material or the paraelectric material.

In some example embodiments, the data storage patterns DSP may be variable resistance patterns that may be switched into two resistance states by electrical pulses applied to the memory element. For example, the data storage patterns DSP may include a phase-change material whose crystal state changes depending on the amount of current, perovskite compounds, transition metal oxide, magnetic materials, ferromagnetic materials or antiferromagnetic materials

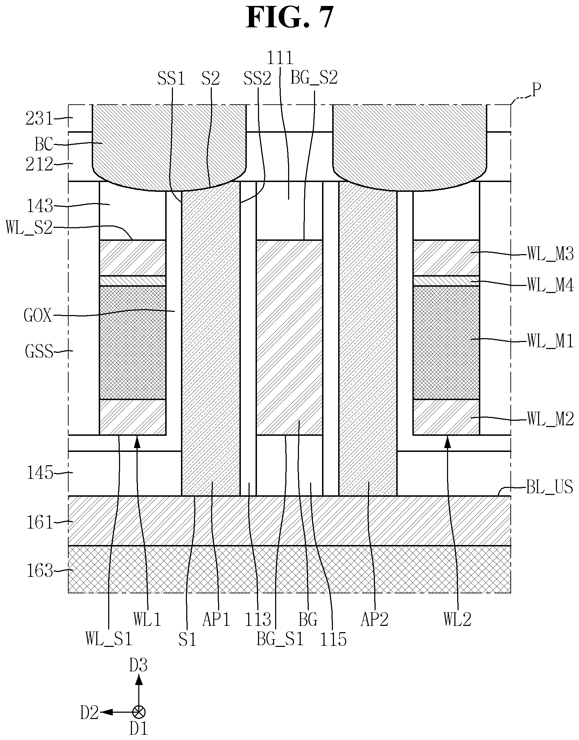

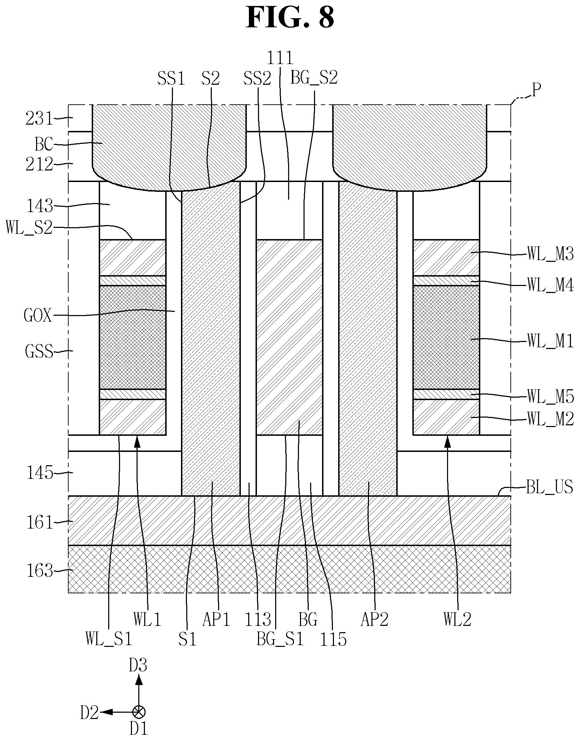

FIGS. 7 and 8 are diagrams for explaining a semiconductor memory device according to some example embodiments. For convenience of explanation, points different from those described using FIGS. 1 to 6 will be mainly explained.

Referring to FIGS. 7 and 8, in the semiconductor memory device according to some example embodiments, each of the first word line WL1 and the second word line WL2 may further include a fourth line pattern WL_M4.

The fourth line pattern WL_M4 may be disposed between the first line pattern WL_M1 and the third line pattern WL_M3.

The fourth line pattern WL_M4 may include a material different from the first line pattern WL_M1 and the third line pattern WL_M3. The fourth line pattern WL_M4 may include a fourth conductive material different from the first conductive material and the third conductive material. The fourth line pattern WL_M4 may include, for example, at least one of a conductive semiconductor material, conductive metal nitride, conductive metal silicon nitride, conductive metal carbonitride, conductive metal silicide, conductive metal oxide, a two-dimensional material, or metal.

As shown in FIG. 7, the first line pattern WL_M1 may be in contact with the second line pattern WL_M2.

Alternatively, as shown in FIG. 8, each of the first word line WL1 and the second word line WL2 may further include a fifth line pattern WL_M5 disposed between the first line pattern WL_M1 and the second line pattern WL_M2. The fifth line pattern WL_M5 may include a fifth conductive material different from the first conductive material and the second conductive material.

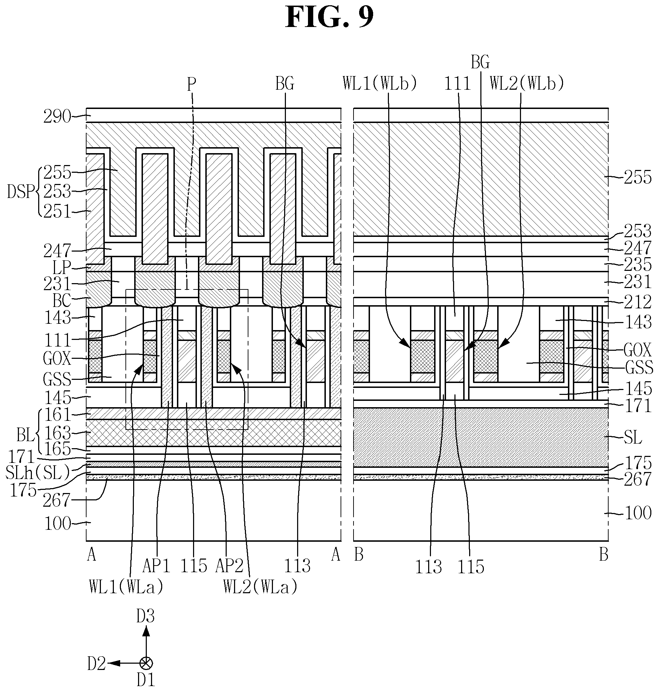

FIGS. 9 to 12 are diagrams for explaining a semiconductor memory device according to an example embodiment. For convenience of explanation, points different from those described using FIGS. 1 to 6 will be mainly explained.

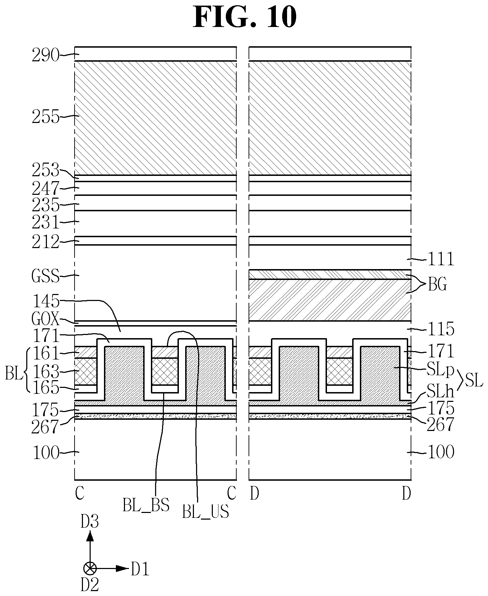

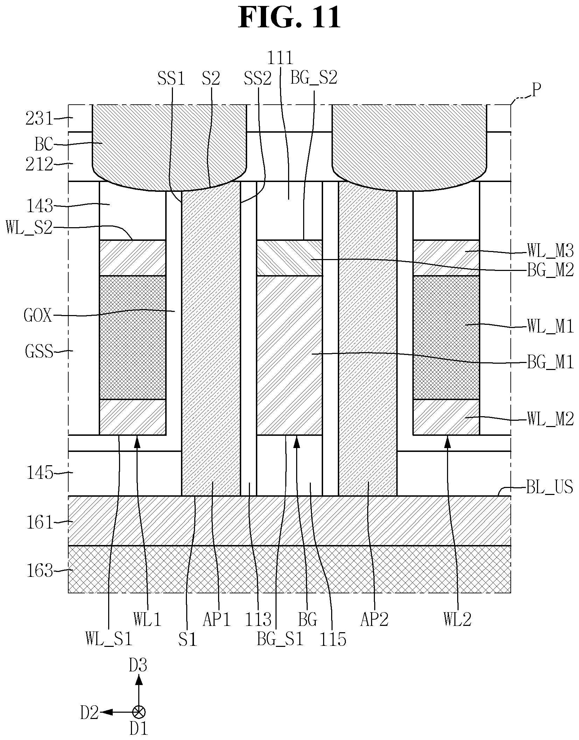

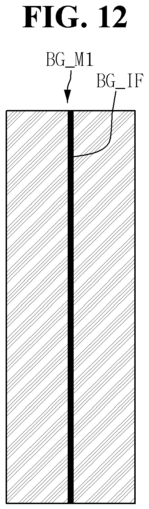

For reference, FIG. 9 is a cross-sectional view taken along lines A-A and B-B of FIG. 1. FIG. 10 is a cross-sectional view taken along lines C-C and D-D of FIG. 1. FIG. 11 is an enlarged view of a portion P of FIG. 9. FIG. 12 is an enlarged view of the first electrode pattern of FIG. 11.

Referring to FIGS. 9 to 12, in the semiconductor memory device according to an example embodiment, the back gate electrode BG may include a plurality of electrode patterns BG_M1 and BG_M2.

The back gate electrode BG may include a first electrode pattern BG_M1 and a second electrode pattern BG_M2. For example, the first electrode pattern BG_M1 and the second electrode pattern BG_M2 may be stacked in the third direction D3.

The first electrode pattern BG_M1 may be in contact with the second electrode pattern BG_M2. The first electrode pattern BG_M1 may include a first surface BG_S1 of the back gate electrode. The second electrode pattern BG_M2 may include a second surface BG_S2 of the back gate electrode.

The first electrode pattern BG_M1 may include a sixth conductive material. The second electrode pattern BG_M2 may include a seventh conductive material different from the sixth conductive material. A work function of the sixth conductive material is different from a work function of the seventh conductive material. Each of the first electrode pattern BG_M1 and the second electrode pattern BG_M2 may include, for example, at least one of a conductive semiconductor material, conductive metal nitride, conductive metal silicon nitride, metal carbonitride, conductive metal silicide, conductive metal oxide, a two-dimensional material, or metal.

At least one of the first electrode pattern BG_M1 and the second electrode pattern BG_M2 may include an electrode internal interface BG_IF. The first electrode pattern BG_M1 will be explained as an example.

As shown in FIG. 12, the first electrode pattern BG_M1 may include the electrode internal interface BG_IF. The electrode internal interface BG_IF may define an interface (e.g. a break or discontinuity in the structure of the first electrode pattern BG_M1). The electrode internal interface BG_IF may extend in the third direction D3. The electrode internal interface BG_IF may extend from the upper surface of the first electrode pattern BG_M1 to the bottom surface of the first electrode pattern BG_M1. The upper surface of the first electrode pattern BG_M1 is opposite to the bottom surface of the first electrode pattern BG_M1 in the third direction D3. The bottom surface of the first electrode pattern BG_M1 may look at (e.g. may face) the bit line BL.

In some example embodiments, the electrode internal interface BG_IF may not extend up to the upper surface of the first electrode pattern BG_M1. As another example, the electrode internal interface BG_IF may not extend up to the bottom surface of the first electrode pattern BG_M1.

In some example embodiments, the first electrode pattern BG_M1 may not include the electrode internal interface BG_IF, similarly to that shown in FIG. 6.

It goes without saying that the explanation about the first electrode pattern BG_M1 may be applied to the second electrode pattern BG_M2.

A voltage is applied to the back gate electrode BG at the time of operation of the semiconductor memory device, and the threshold voltage of the vertical channel transistor may be adjusted. A negative voltage may be applied to the back gate electrode BG to adjust the threshold voltage of the vertical channel transistor. Because the negative voltage is applied to the back gate electrode BG, the gate induced drain leakage (GIDL) of the vertical channel transistor may deteriorate. Because the back gate electrode BG has a multi film structure including different materials from each other, the gate induced drain leakage (GIDL) characteristics of the vertical channel transistor may be improved.

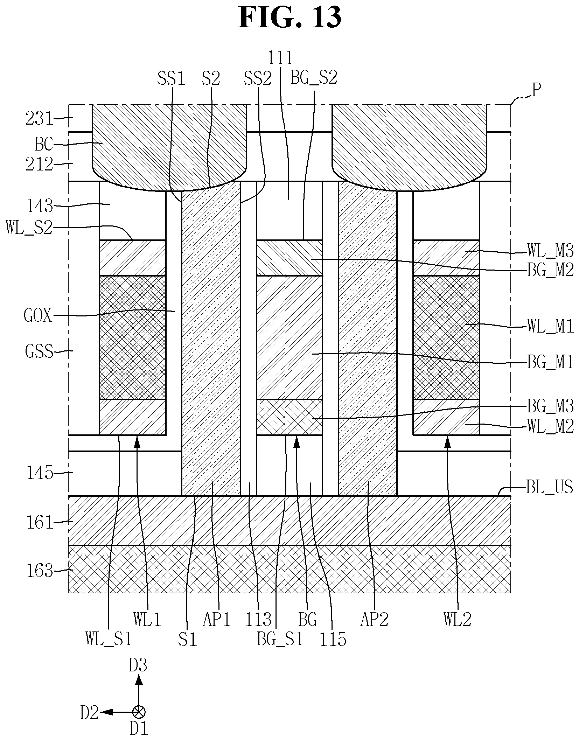

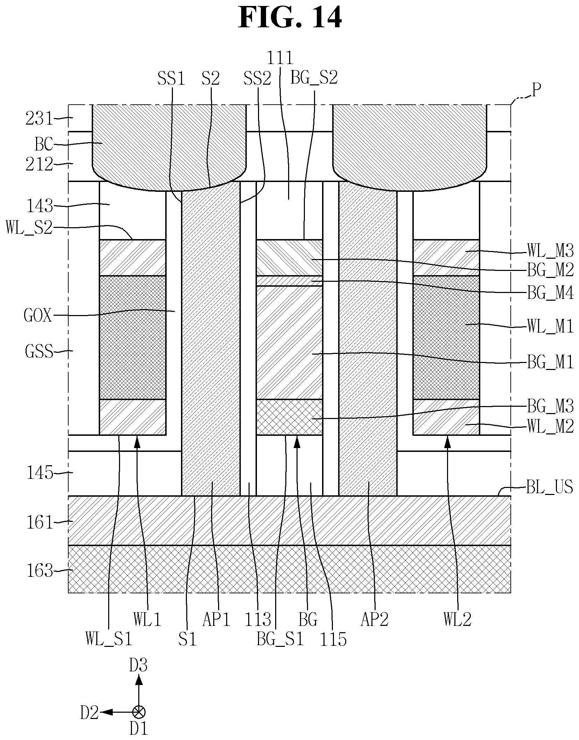

FIGS. 13 and 14 are diagrams for explaining a semiconductor memory device according to some example embodiments. For convenience of explanation, the explanation will focus on the points that are different from those explained using FIGS. 9 to 12.

For reference, FIGS. 13 and 14 are enlarged views of a portion P of FIG. 9, respectively.

Referring to FIGS. 13 and 14, in the semiconductor memory device according to some example embodiments, the back gate electrode BG may further include a third electrode pattern BG_M3.

The first electrode pattern BG_M1 may be disposed between the second electrode pattern BG_M2 and the third electrode pattern BG_M3.

The third electrode pattern BG_M3 may include a material different from the first electrode pattern BG_M1. The third electrode pattern BG_M3 may include an eighth conductive material different from the sixth conductive material. The third electrode pattern BG_M3 may include, for example, at least one of a conductive semiconductor material, a conductive metal nitride, a conductive metal silicon nitride, a metal carbonitride, a conductive metal silicide, a conductive metal oxide, a two-dimensional material, and a metal.

As shown in FIG. 13, the first electrode pattern BG_M1 may be in contact with the second electrode pattern BG_M2 and the third electrode pattern BG_M3.

Alternatively, as shown in FIG. 14, the back gate electrode BG may further include a fourth electrode pattern BG_M4 disposed between the first electrode pattern BG_M1 and the second electrode pattern BG_M2. The fourth electrode pattern BG_M4 may include a ninth conductive material different from the sixth conductive material and the seventh conductive material. In some example embodiments, the fourth electrode pattern BG_M4 may be disposed between the first electrode pattern BG_M1 and the third electrode pattern BG_M3.

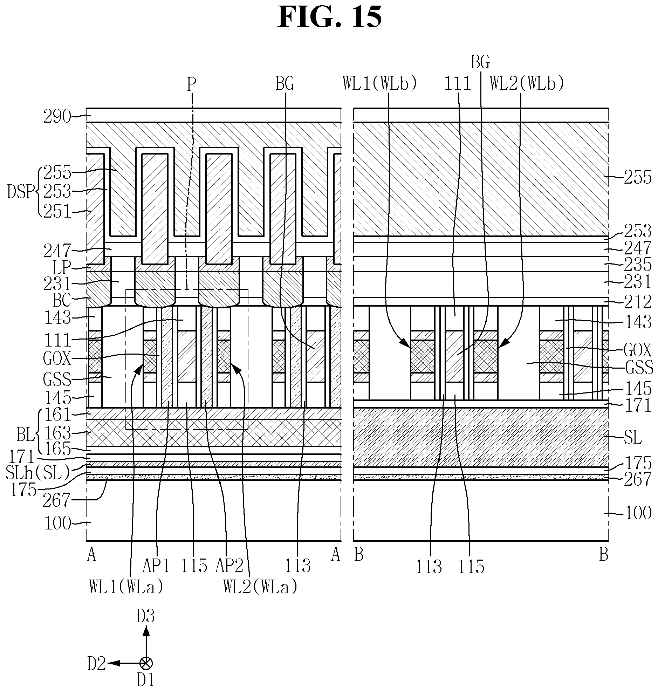

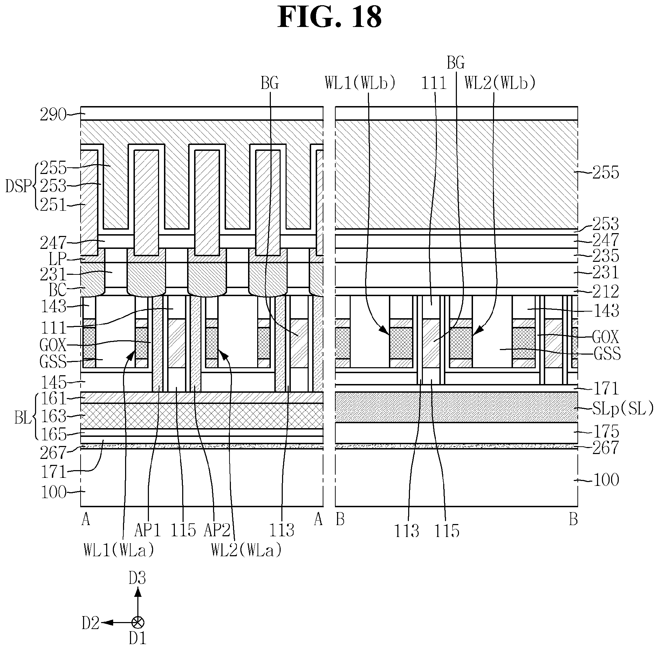

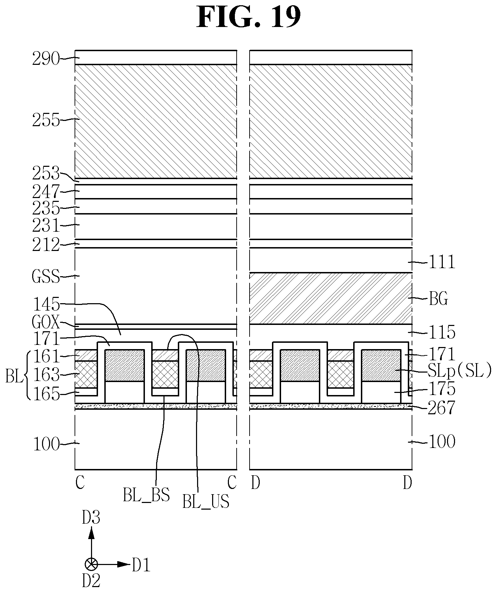

FIGS. 15 to 17 are diagrams for explaining a semiconductor memory device according to an example embodiment. FIGS. 18 and 19 are diagrams for explaining the semiconductor memory device according to an example embodiment. For convenience of explanation, points different from those described using FIGS. 1 to 6 will be mainly explained.

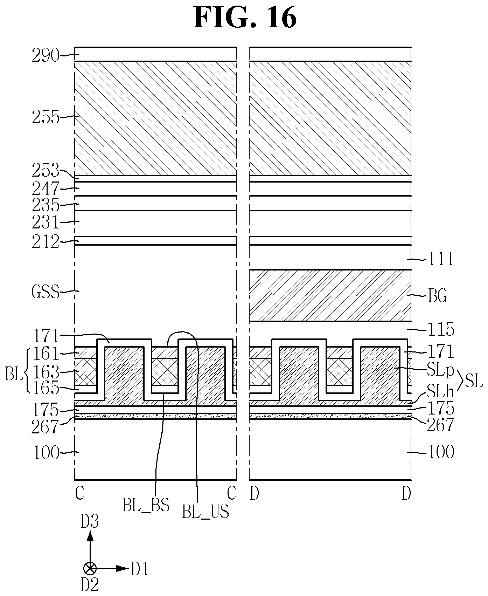

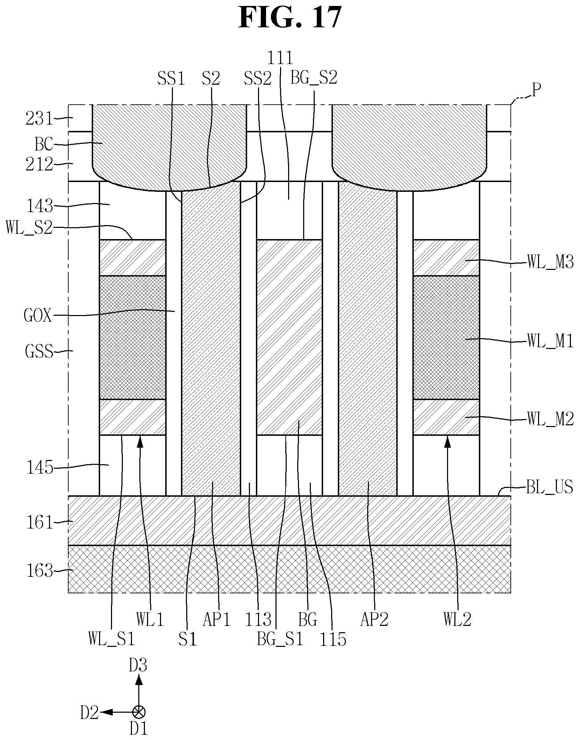

For reference, FIGS. 15 and 18 are cross-sectional views taken along lines A-A and B-B of FIG. 1, respectively. FIGS. 16 and 19 are cross-sectional views taken along lines C-C and D-D of FIG. 1, respectively. FIG. 17 is an enlarged view of a portion P of FIG. 15.

Referring to FIGS. 15 to 17, in the semiconductor memory device according to an example embodiment, the gate insulating pattern GOX may be disposed between the first active pattern AP1 and the gate shielding pattern 145, and between the second active pattern AP2 and the gate shielding pattern 145.

The gate shielding pattern 145 may be disposed between the first active pattern AP1 and the gate separation pattern GSS, and between the second active pattern AP2 and the gate separation pattern GSS.

From the viewpoint of the cross-sectional view, the gate shielding pattern 145 between the first word line WL1 and the bit line BL may be spaced apart from the gate shielding pattern 145 between the second word line WL2 and the bit line BL in the second direction D2.

Referring to FIGS. 18 and 19, in the semiconductor memory device according to an example embodiment, the shielding conductive pattern SL may include a plurality of shielding conductive line patterns SLp without a shielding conductive plate SLh.

The shielding conductive pattern SL may not be disposed on the bottom surface BL_BS of the bit line BL (e.g. may not be disposed directly below the bit line BL). For example, the shielding insulating capping film 175 may be in contact with the shielding conductive line pattern SLp.

The shielding insulating capping film 175 may have a line shape extending in the second direction D2 along the shielding conductive line pattern SLp.

In some example embodiments, the shielding insulating capping film 175 may have a flat plate shape. In other words, the shielding insulating capping film 175 may overlap the shielding conductive line pattern SLp and the bit line BL in the third direction D3.

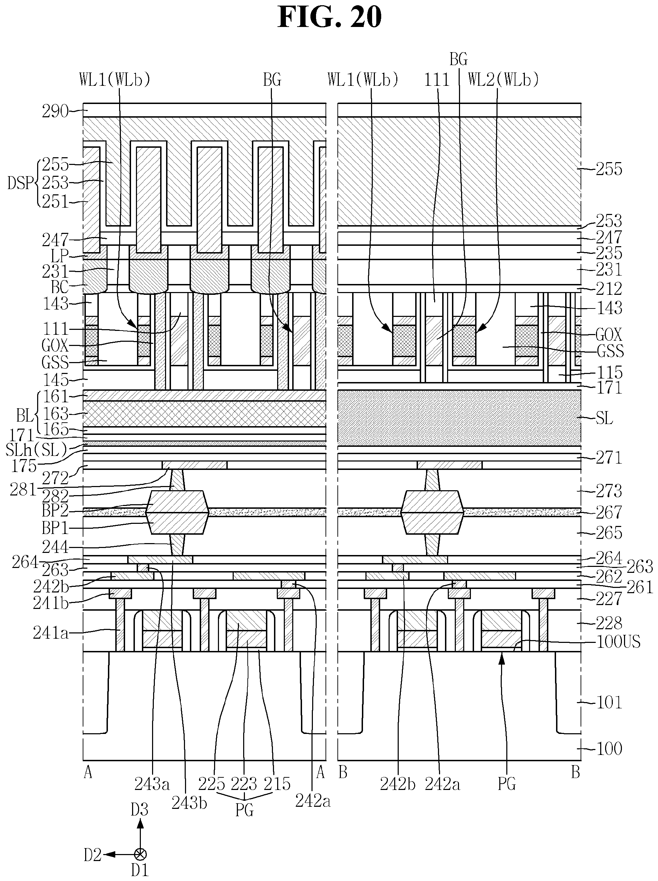

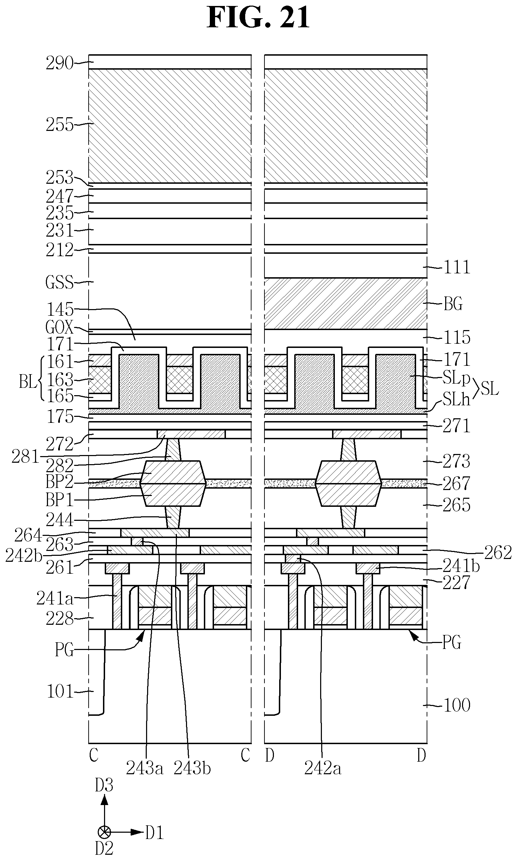

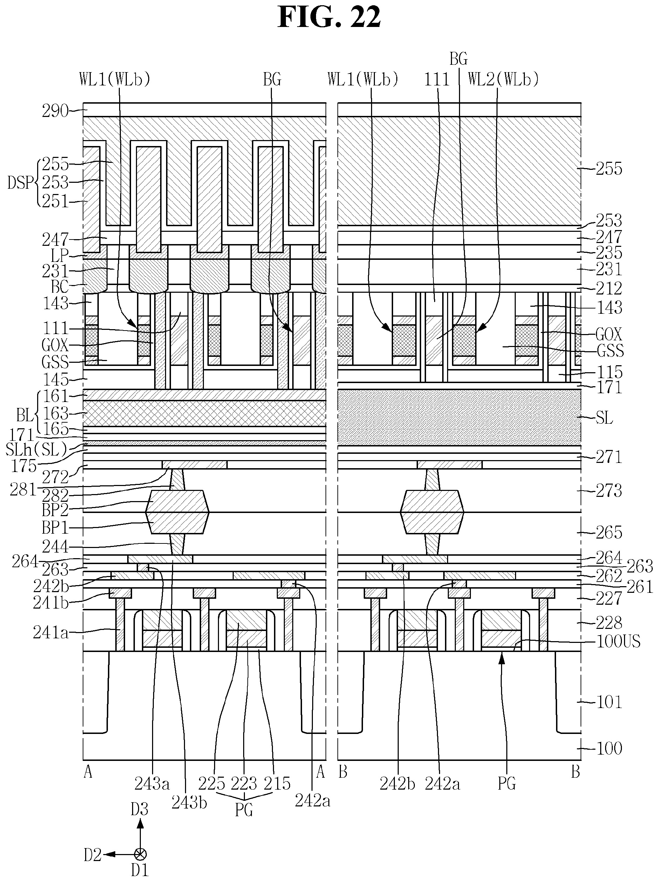

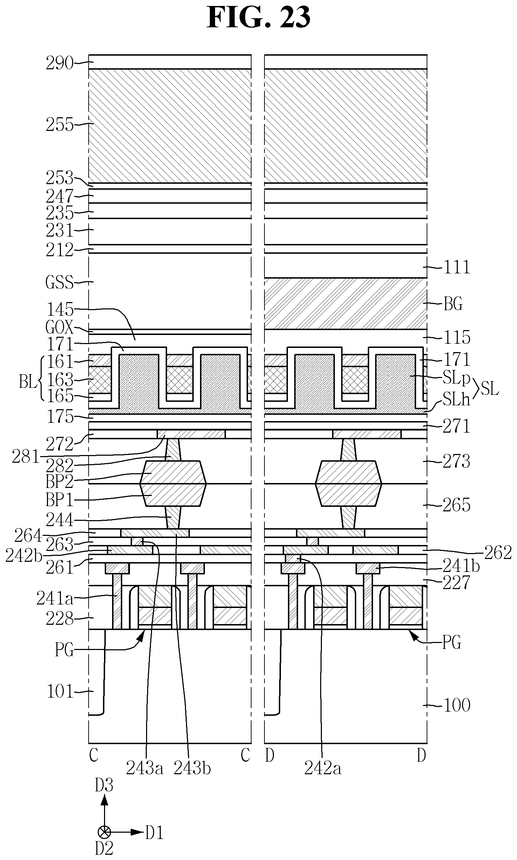

FIGS. 20 and 21 are diagrams for explaining a semiconductor memory device according to an example embodiment. FIGS. 22 and 23 are diagrams for explaining the semiconductor memory device according to an example embodiment. For convenience of explanation, points different from those described using FIGS. 1 to 6 will be mainly explained.

For reference, FIGS. 20 and 22 are cross-sectional views taken along lines A-A and B-B of FIG. 1, respectively. FIGS. 21 and 23 are cross-sectional views taken along lines C-C and D-D of FIG. 1, respectively.

Referring to FIGS. 20 to 23, the semiconductor memory device according to some example embodiments may further include a peri-gate structure PG (e.g. a peripheral gate structure) disposed between the substrate 100 and the bit line BL.

The peri-gate structure PG may be disposed on the substrate 100. For example, the peri-gate structure PG may be disposed on the upper surface 100US of the substrate. The peri-gate structure PG may be disposed over the cell array region and the peripheral circuit region. In other words, a part of the peri-gate structure PG is disposed in the cell array region of the substrate 100, and the rest of the peri-gate structure PG may be disposed in the peripheral circuit region of the substrate 100.

The peri-gate structure PG may be included in a sensing transistor, a transfer transistor, a drive transistor, etc. For example, the peri-gate structure PG included in the sensing transistor may, but not limited to, be disposed on the cell array region of the substrate 100. It goes without saying that the types of transistors of the peripheral circuits disposed on the cell array region of the substrate 100 may vary depending on the design placement of the semiconductor memory device.

The peri-gate structure PG may include a peri-gate insulating film 215, a peri-lower conductive pattern 223, and a peri-upper conductive pattern 225. The peri-gate insulating film 215 may include, but not limited to, at least one of a silicon oxide film, a silicon oxynitride film, a high dielectric constant insulating film having a higher dielectric constant than a silicon oxide film, or a combination thereof. The high dielectric constant insulating film may include, for example, but not limited to, at least one of metal oxide, metal oxynitride, metal silicon oxide, or metal silicon oxynitride.

The peri-lower conductive pattern 223 and the peri-upper conductive pattern 225 each include a conductive material. For example, the peri-lower conductive pattern 223 and the peri-upper conductive pattern 225 may each include at least one of a doped semiconductor material, conductive metal nitride, conductive metal silicon nitride, metal carbonitride, conductive metal silicide, conductive metal oxide, a two-dimensional (2D) material, or metal. Although the peri-gate structure PG is shown to include a plurality of conductive patterns, example embodiments are not limited thereto.

Although it is not shown, the peri-gate structure PG may further include a peri-gate mask pattern disposed on the peri-upper conductive pattern 225. The peri-gate mask pattern is formed of an insulating material.

The first peri-lower insulating film 227 and the second peri-lower insulating film 228 are disposed on the upper surface 100US of the substrate. The first peri-lower insulating film 227 and the second peri-lower insulating film 228 each include an insulating material.

A peri-contact plug 241a and a peri-wiring line 241b may be disposed inside the first peri-lower insulating film 227 and the second peri-lower insulating film 228. The peri-contact plug 241a and the peri-wiring line 241b may be connected to the conductive patterns 223 and 225 of the peri-gate structure PG. Although it is not shown, the peri-contact plug 241a and the peri-wiring line 241b may be connected to a source/drain region disposed on at least one side of the peri-gate structure PG.

Although the peri-contact plug 241a and the peri-wiring line 241b are shown as being different films from each other, example embodiments not limited thereto. A boundary between the peri-contact plug 241a and the peri-wiring line 241b may not be distinguished. The peri-contact plug 241a and the peri-wiring line 241b each include a conductive material.

The first peri-upper insulating film 261 and the second peri-upper insulating film 262 may be disposed on the peri-contact plug 241a and the peri-wiring line 241b. The first peri-upper insulating film 261 and the second peri-upper insulating film 262 each include an insulating material. It goes without saying that, in some example embodiments, the first peri-upper insulating film 261 and the second peri-upper insulating film 262 may be formed of a single film, on the peri-contact plug 241a and the peri-wiring line 241b.

The first peri-connecting structures 242a and 242b may be connected to the peri-wiring line 241b. The first peri-connecting structures 242a and 242b may include a first peri-connecting via 242a and a first peri-connecting wiring 242b. The first peri-connecting via 242a and the first peri-connecting wiring 242b each include a conductive material. Although the first peri-connecting via 242a and the first peri-connecting wiring 242b are shown as being formed of films different from each other, example embodiments are not limited thereto.

A third peri-upper insulating film 263 and a fourth peri-upper insulating film 264 may be disposed on the first peri-connecting structures 242a and 242b. The third peri-upper insulating film 263 and the fourth peri-upper insulating film 264 each include an insulating material. It goes without saying that, in some example embodiments, the third peri-upper insulating film 263 and the fourth peri-upper insulating film 264 may be formed of a single film, on the first peri-connecting structures 242a and 242b.

The second peri-connecting structures 243a and 243b may be connected to the first peri-connecting wiring 242b. The second peri-connecting structures 243a and 243b may include a second peri-connecting via 243a and a second peri-connecting wiring 243b. The second peri-connecting via 243a and the second peri-connecting wiring 243b each include a conductive material. Although the second peri-connecting via 243a and the second peri-connecting wiring 243b are shown as being films different from each other, the embodiment is not limited thereto.

Although the first peri-connecting structures 242a and 242b and the second peri-connecting structures 243a and 243b are shown as being disposed on the peri-gate structure PG, example embodiments are not limited thereto. It goes without saying that, in some example embodiments, only one peri-connecting structure may be disposed on the peri-gate structure PG.

A fifth peri-upper insulating film 265 may be disposed on the second peri-connecting structures 243a and 243b. The fifth peri-upper insulating film 265 includes an insulating material.

A lower bonding pad BP1 may be disposed on the peri-gate structure PG. The lower bonding pad BP1 may be connected to the second peri-connecting structures 243a and 243b.

For example, at least one of the lower bonding pads BP1 may be connected to the peri-gate structure PG. At least the other of the lower bonding pads BP11 may be connected to a source/drain region disposed on at least one side of the peri-gate structure PG.

A lower pad plug 244 may connect the lower bonding pad BP1 and the second peri-connecting wiring 243b. The lower bonding pad BP1 and the lower pad plug 244 may be disposed inside the fifth peri-upper insulating film 265.

A first cell lower insulating film 271, a second cell lower insulating film 272, and a third cell lower insulating film 273 may be disposed on the fifth peri-upper insulating film 265. The first cell lower insulating film 271, the second cell lower insulating film 272, and the third cell lower insulating film 273 may be disposed on the lower bonding pad BP1.

The second cell lower insulating film 272 may be disposed between the first cell lower insulating film 271 and the third cell lower insulating film 273. The third cell lower insulating film 273 may be disposed between the second cell lower insulating film 272 and the fifth peri-upper insulating film 265. The first cell lower insulating film 271, the second cell lower insulating film 272, and the third cell lower insulating film 273 each include an insulating material.

An upper bonding pad BP2 may be disposed on the lower bonding pad BP1. The upper bonding pad BP2 may be disposed on the fifth peri-upper insulating film 265.

The upper bonding pad BP2 may be connected to the lower bonding pad BP1. The upper bonding pad BP2 may be in contact with the lower bonding pad BP1.

A cell connecting wiring 281 may be disposed on the upper bonding pad BP2. The cell connecting wiring 281 may be disposed between the upper bonding pad BP2 and the bit line BL. The cell connecting wiring 281 may be disposed between the upper bonding pad BP2 and the shielding conductive pattern SL.

Although it is not shown, the cell connecting wiring 281 may be connected to at least one of the bit line BL or the shielding conductive pattern SL.

Although the cell connecting wiring 281 disposed on one metal level is shown as being disposed between the upper bonding pad BP2 and the bit line BL, this is only for convenience of explanation, and example embodiments are not limited thereto. A plurality of cell connecting wirings 281 disposed on metal levels different from each other may be disposed between the upper bonding pad BP2 and the bit line BL.

The upper pad plug 282 may connect the upper bonding pad BP2 and the cell connecting wiring 281. The upper bonding pad BP2 may be connected to the cell connecting wiring 281 through the upper pad plug 282.

The upper bonding pad BP2 and the upper pad plug 282 may be disposed inside the third cell lower insulating film 273. The cell connecting wiring 281 may be disposed inside the second cell lower insulating film 272.

The upper pad plug 282 and the lower pad plug 244 may include a conductive material including a metal. The lower bonding pad BP1 and the upper bonding pad BP2 may each include a conductive material including metal. The cell connecting wiring 281 may include a conductive material including metal.

Although the lower bonding pad BP1 and the upper bonding pad BP2 are each shown as being a single film, this is only for convenience of explanation, and example embodiments are not limited thereto. Although the upper pad plug 282 and the lower pad plug 244 are each shown as being a single film, example embodiments are not limited thereto. Although the cell connecting wiring 281 is shown as being a single film, example embodiments are not limited thereto.

The shielding conductive pattern SL and the bit line BL may be disposed on the peri-gate structure PG. The shielding conductive pattern SL and the bit line BL may be disposed on the upper bonding pad BP2. For example, the shielding conductive pattern SL and the bit line BL may be disposed on the cell connecting wiring 281.

The first cell lower insulating film 271 may be disposed between the bit line BL and the cell connecting wiring 281, and between the shielding conductive pattern SL and the cell connecting wiring 281. The first cell lower insulating film 271 may be disposed between the shielding insulating liner 171 and the second cell lower insulating film 272, and between the shielding insulating capping film 175 and the second cell lower insulating film 272.

The cell upper insulating film 290 may be disposed on the data storage pattern DSP. The cell upper insulating film 290 includes an insulating material.

As shown in FIGS. 20 and 21, the bonding insulating film 267 may be disposed between the third cell lower insulating film 273 and the fifth peri-upper insulating film 265. The bonding insulating film 267 may be disposed between the peri-gate structure PG and the shielding conductive pattern SL.

The bonding insulating film 267 may be disposed along an extension line of the interface between the lower bonding pad BP1 and the upper bonding pad BP2. The interface between the lower bonding pad BP1 and the upper bonding pad BP2 may be a boundary between the lower bonding pad BP1 and the upper bonding pad BP2.

Alternatively, as shown in FIGS. 22 and 23, the bonding insulating film (267 of FIGS. 20 and 21) may not be disposed along the extension line of the interface between the lower bonding pad BP1 and the upper bonding pad BP2. The third cell lower insulating film 273 may be in contact with the fifth peri-upper insulating film 265.

At the interface between the lower bonding pad BP1 and the upper bonding pad BP2, a width of the lower bonding pad BP1 may be equal to a width of the upper bonding pad BP2. In some example embodiments, at the interface between the lower bonding pad BP1 and the upper bonding pad BP2, the width of the lower bonding pad BP1 may be different from the width of the upper bonding pad BP2.

At the interface between the lower bonding pad BP1 and the upper bonding pad BP2, the lower bonding pad BP1 may be aligned with the upper bonding pad BP2. In some example embodiments, the lower bonding pad BP1 may be misaligned with the upper bonding pad BP2 at the interface between the lower bonding pad BP1 and the upper bonding pad BP2.

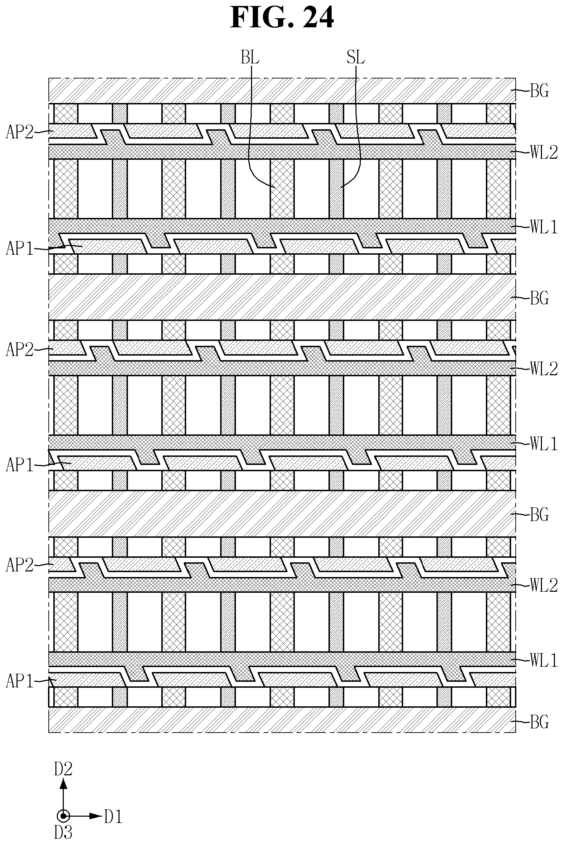

FIGS. 24 to 27 are diagrams for explaining semiconductor memory devices according to some example embodiments, respectively. For convenience of explanation, the explanation will focus on the points that are different from those explained using FIGS. 1 to 23.

Referring to FIG. 24, in the semiconductor memory device according to an example embodiments, the first and second active patterns AP1 and AP2 may be arranged alternately in a diagonal direction with respect to the first direction D1 and the second direction D2. For instance, columns of active patterns may be arranged along the diagonal direction. Here, the diagonal direction may be parallel to the upper surface of the substrate 100.

From the viewpoint of a plan view, each of the first and second active patterns AP1 and AP2 may have a parallelogram shape or a rhombus shape. End faces of each of the first and second active patterns AP1 and AP2 may run parallel to the diagonal direction. Because the first and second active patterns AP1 and AP2 are disposed in the diagonal direction, coupling between the first and second active patterns AP1 and AP2 facing each other in the second direction D2 may be reduced.

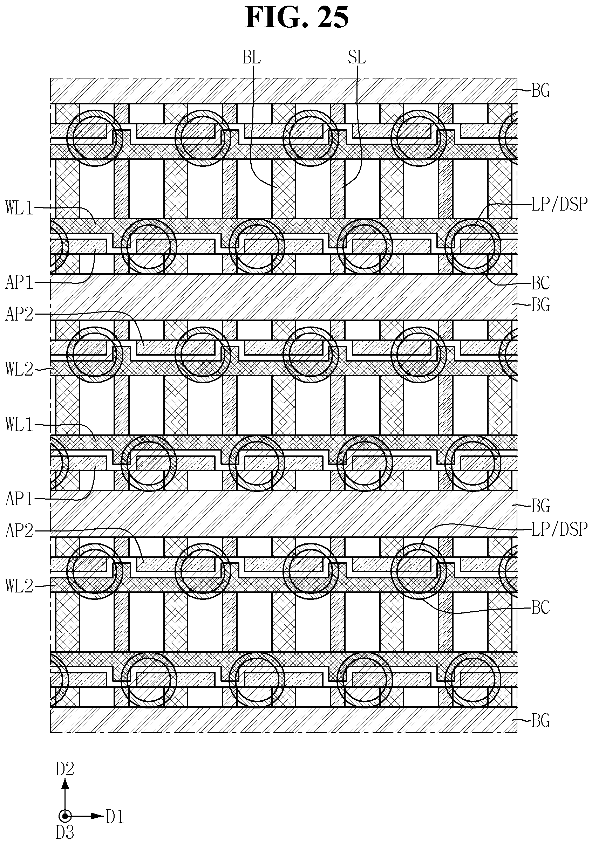

Referring to FIG. 25, in the semiconductor memory device according to an example embodiment, the landing pads LP and the data storage patterns DSP may be arranged in a zigzag or honeycomb form from the viewpoint of a plan view.

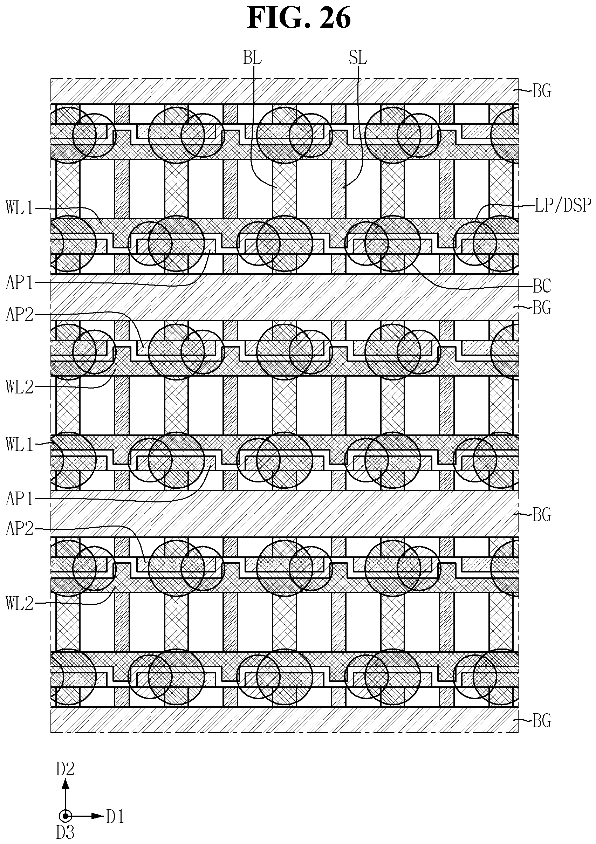

Referring to FIG. 26, in the semiconductor memory device according to an example embodiment, the data storage patterns DSP may be disposed to be misaligned (e.g., to be offset) from the landing pads LP from the viewpoint of a plan view.

Each data storage pattern DSP may be in contact with a part of the landing pad LP.

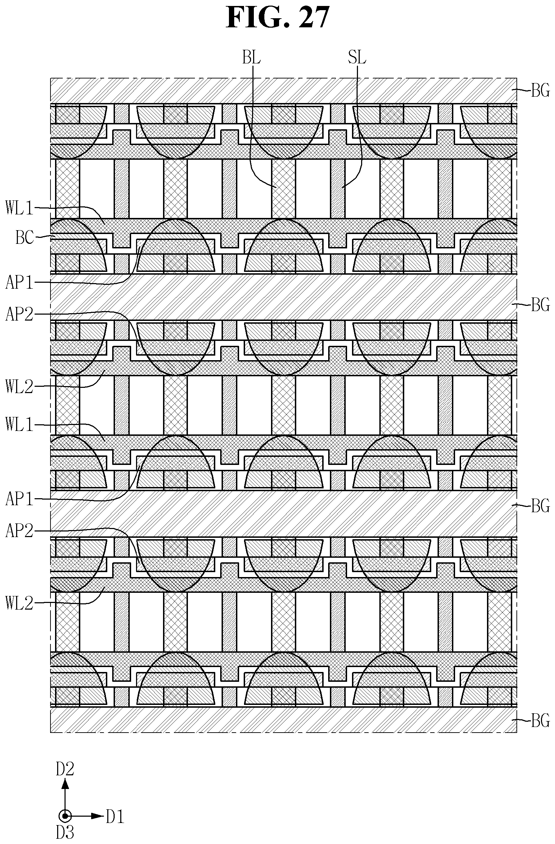

Referring to FIG. 27, in the semiconductor memory device according to an example embodiment, each of the contact patterns BC disposed on the first and second active patterns AP1 and AP2 may have a semicircular shape or an oval shape from the viewpoint of a plan view.

The contact patterns BC may be disposed symmetrically with each other with the back gate electrode BG interposed between them from the viewpoint of a plan view.

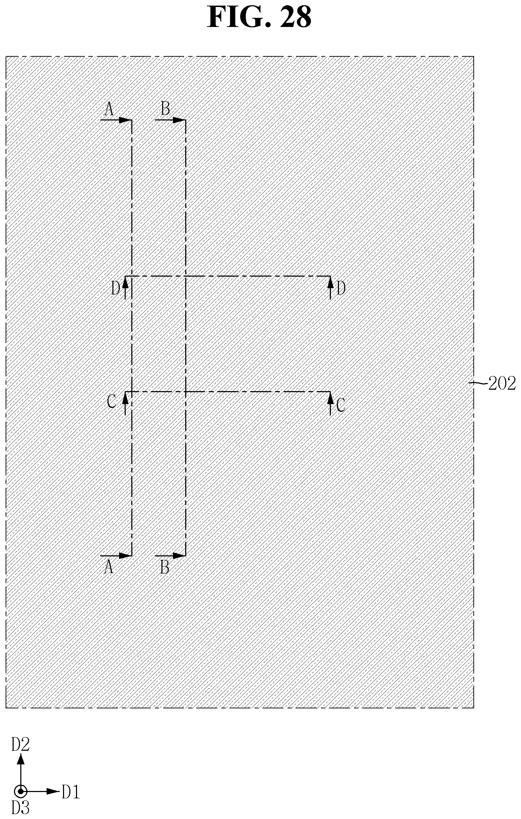

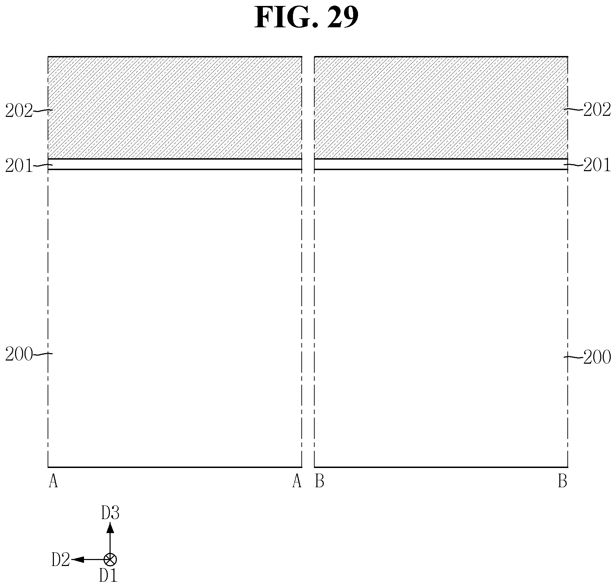

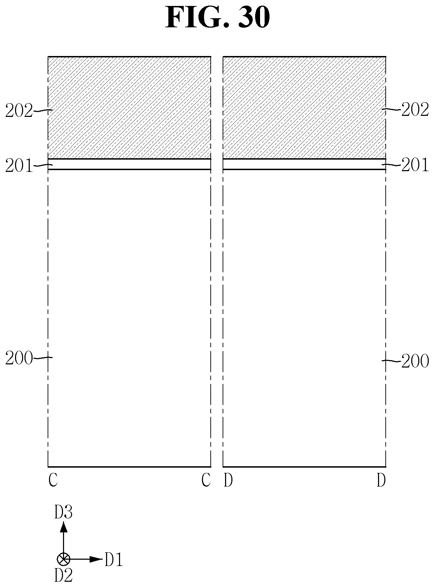

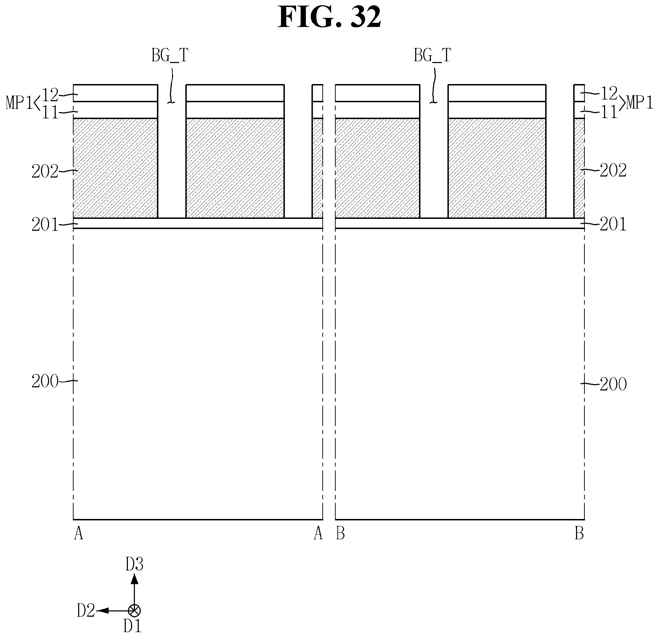

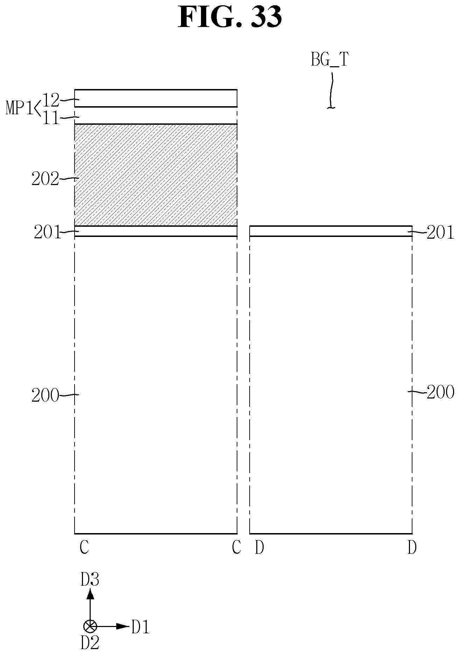

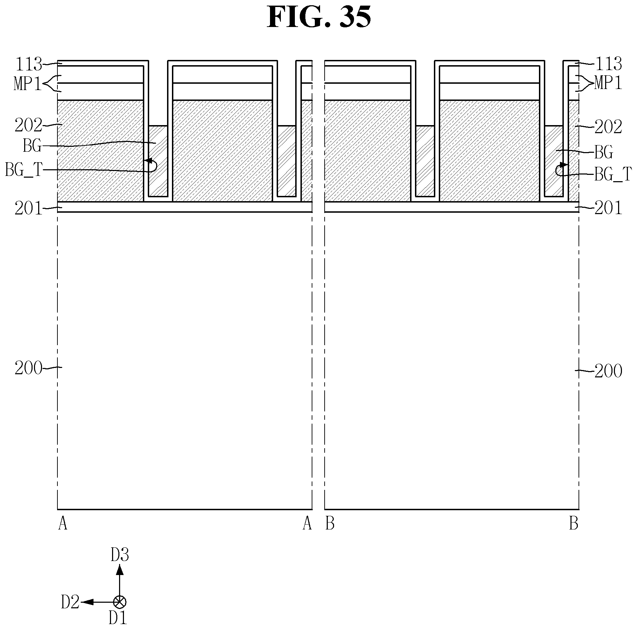

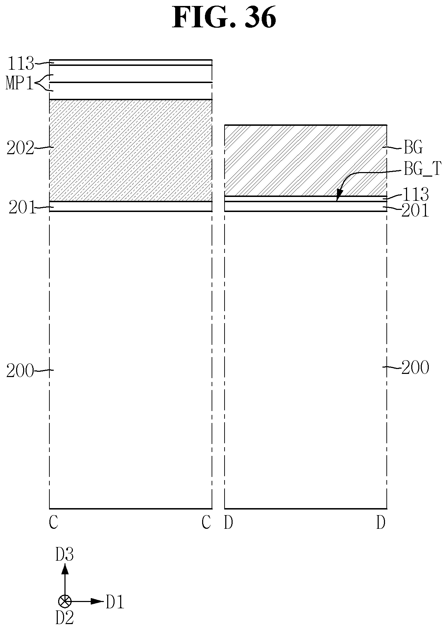

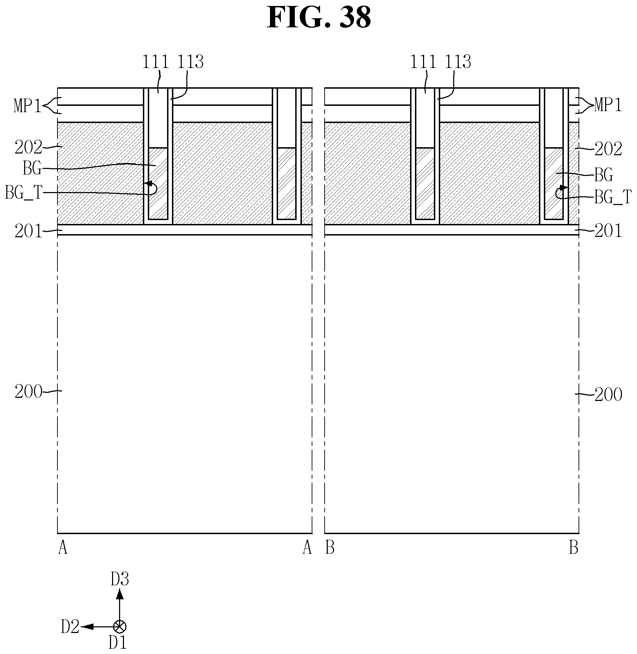

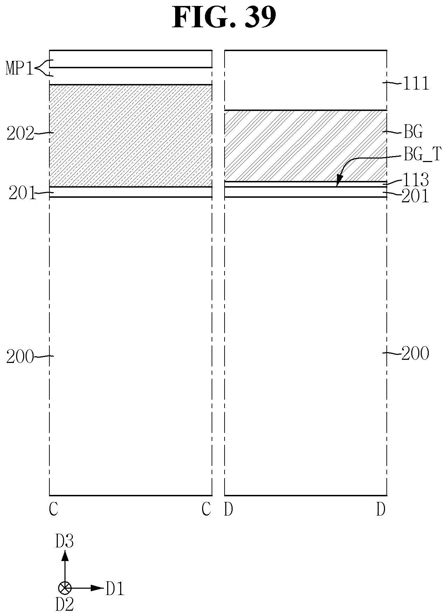

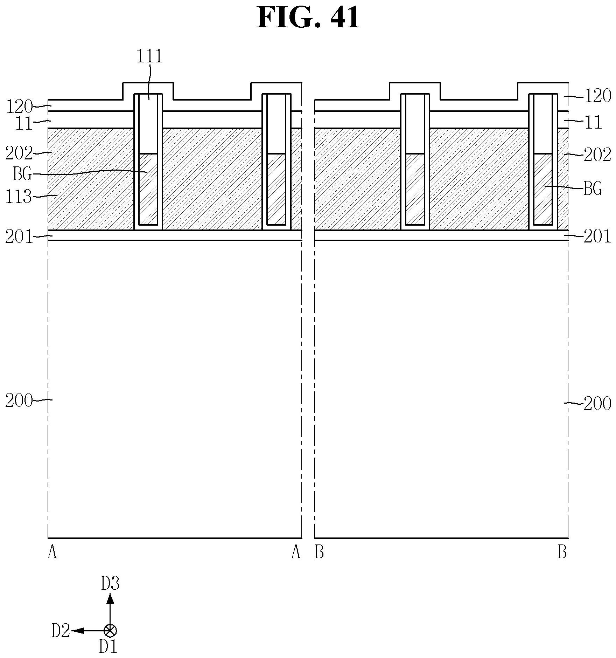

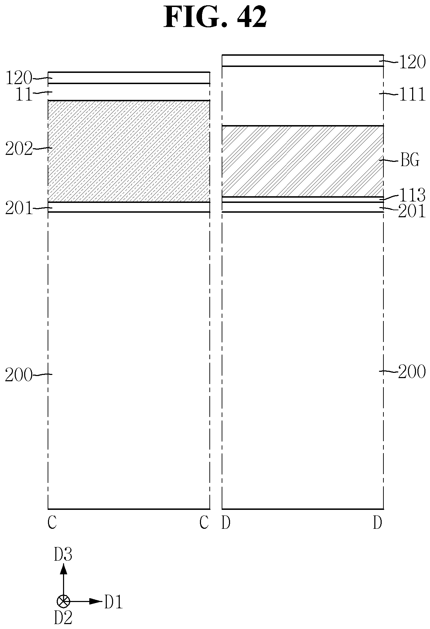

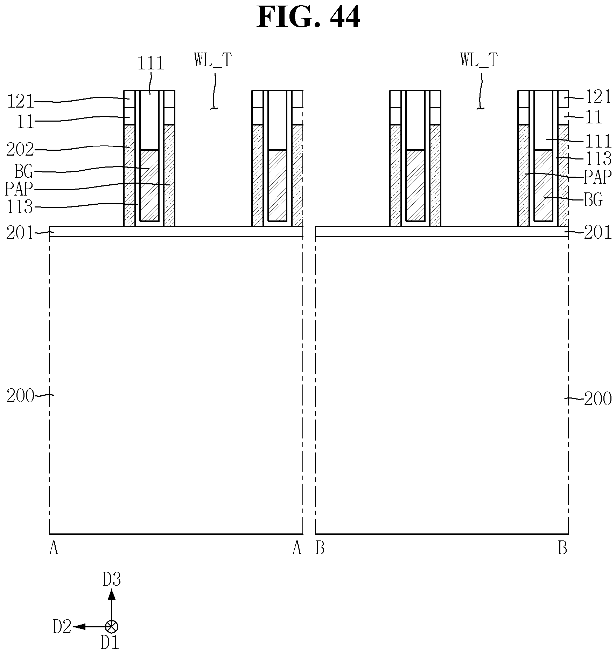

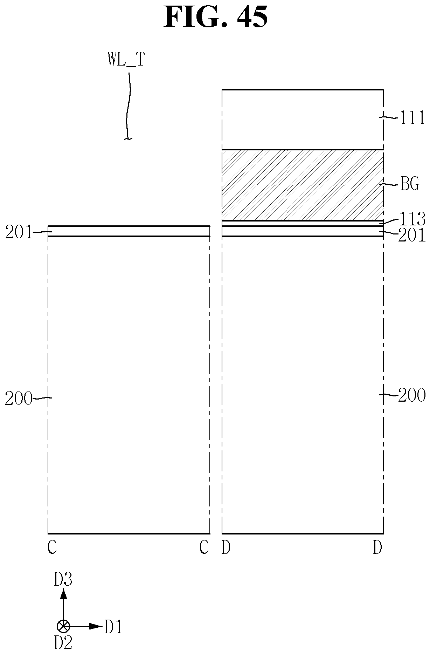

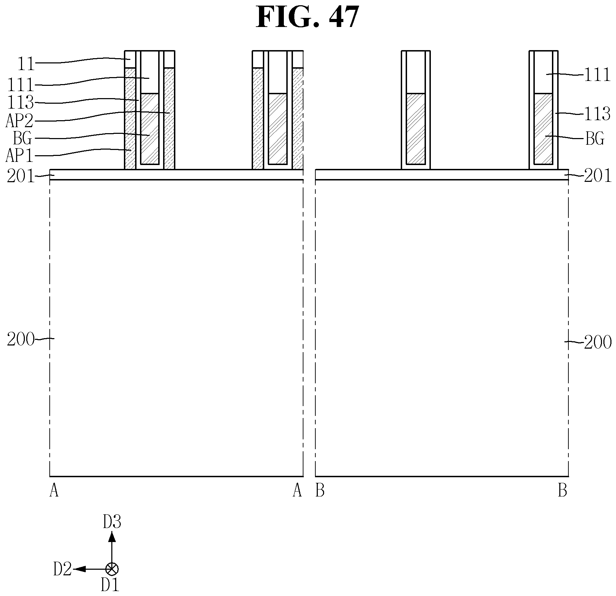

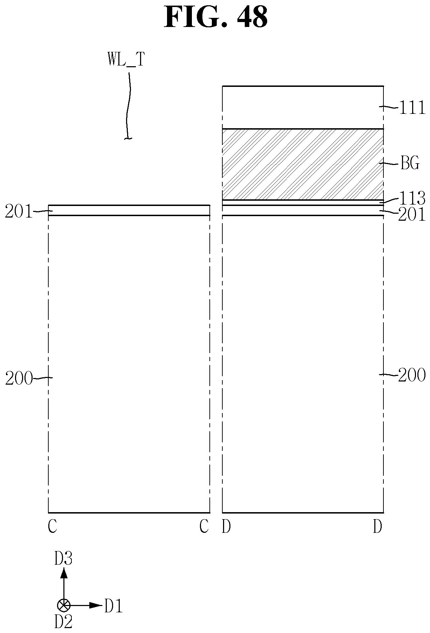

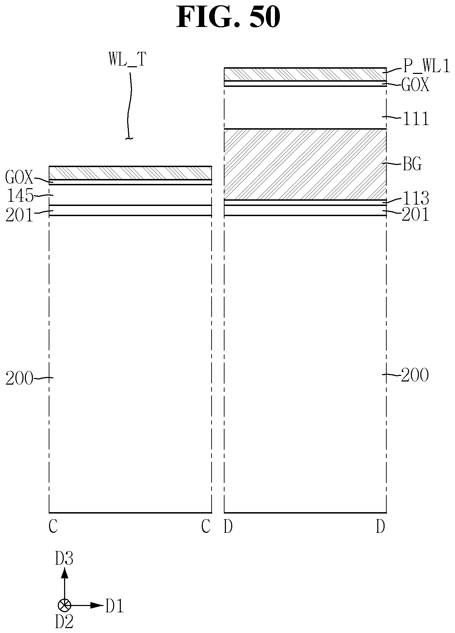

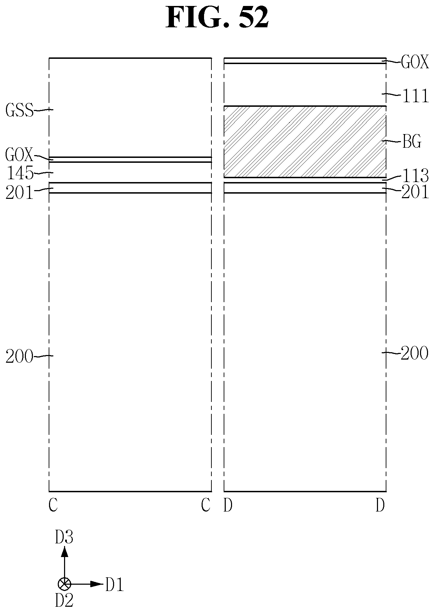

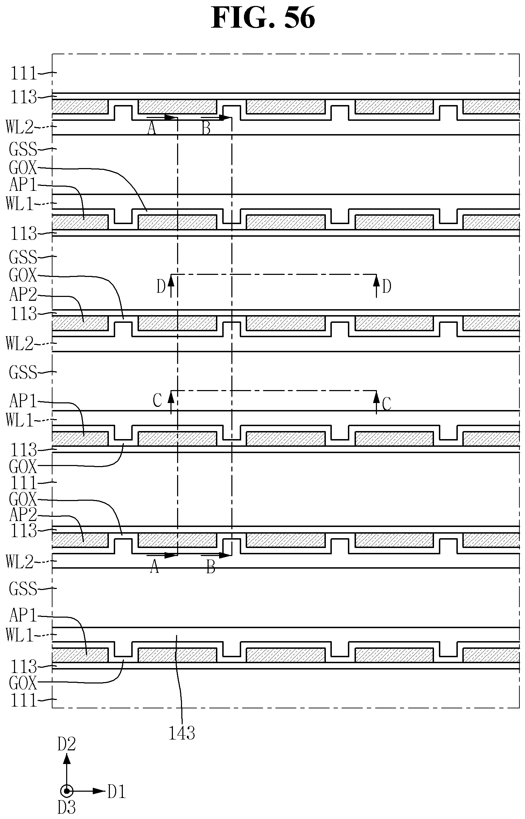

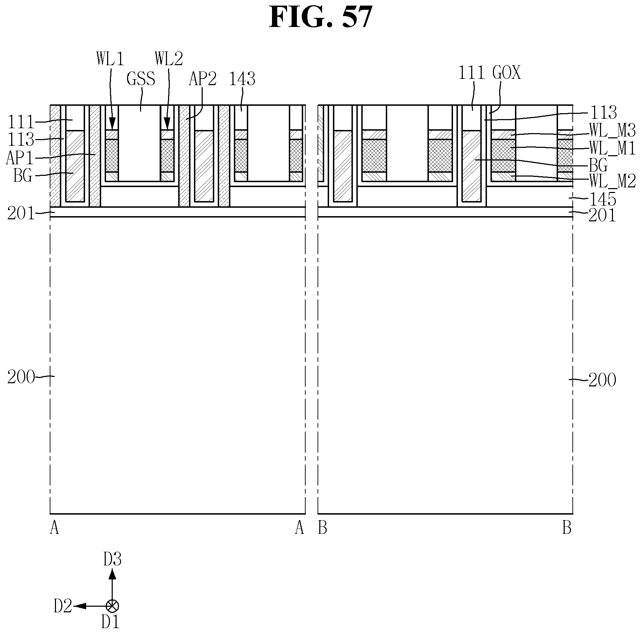

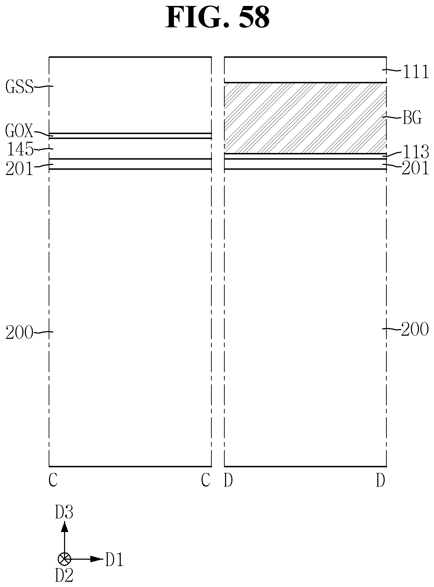

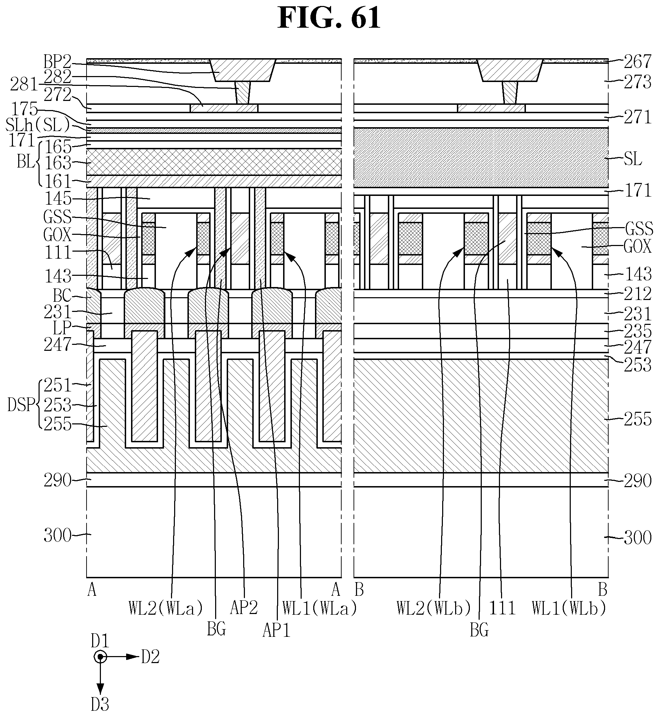

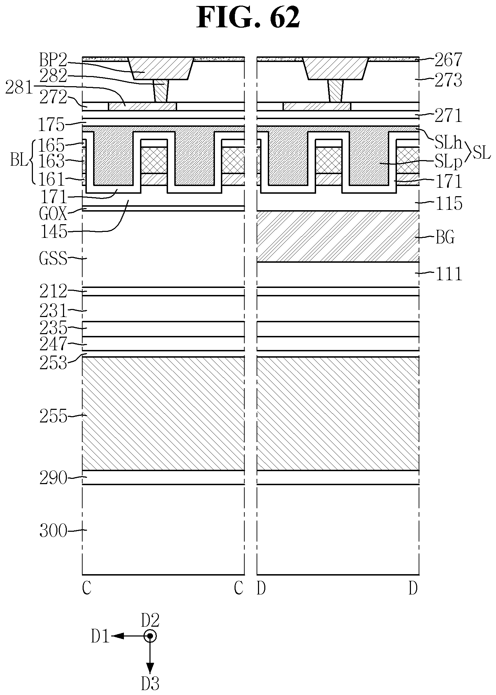

FIGS. 28 to 62 are intermediate stage diagrams for explaining a method for fabricating a semiconductor memory device according to an example embodiment. The semiconductor memory device described using FIGS. 20 and 21 may be fabricated, accordingly.

Referring to FIGS. 28 to 30, a sub-substrate structure which includes a first sub-substrate 200, a buried insulating film 201, and an active layer 202 may be provided.

The buried insulating film 201 and the active layer 202 may be provided on the first sub-substrate 200. The first sub-substrate 200, the buried insulating film 201 and the active layer 202 may be a silicon-on-insulator substrate (i.e., SOI substrate). The first sub-substrate 200 may be a semiconductor substrate. The first sub-substrate 200 may be, for example, a silicon substrate, a germanium substrate, and/or a silicon-germanium substrate. In the following description, the first sub-substrate 200 will be explained as being a silicon substrate.

The buried insulating film 201 may be a buried oxide (BOX) formed by a SIMOX (separation by implanted oxygen) method or a bonding and layer transfer method. In some example embodiments, the buried insulating film 201 may be an insulating film formed by a chemical vapor deposition method. The buried insulating film 201 may include, for example, a silicon oxide film, a silicon nitride film, a silicon oxynitride film, and/or a low dielectric constant insulating film.

The active layer 202 may be a single crystal semiconductor film. The active layer 202 may be, for example, a single crystal silicon substrate, a germanium substrate, and/or a silicon-germanium substrate. The active layer 202 may have a first surface and a second surface that are opposite to each other in the third direction D3, and the second surface of the active layer 202 may be in contact with the buried insulating film 201.

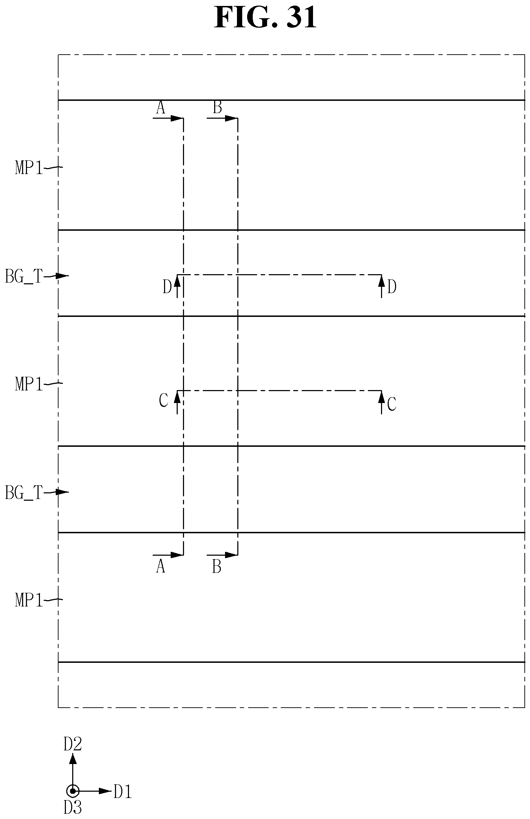

Referring to FIGS. 31 to 33, a mask pattern MP1 may be formed on the active layer 202.

The mask pattern MP1 may have linear openings extending along the first direction D1. The mask pattern MP1 may include a first lower mask film 11 and a first upper mask film 12 that are stacked in sequence. The first upper mask film 12 may be formed of or include a material that has etching selectivity with respect to the first lower mask film 11. As an example, the first lower mask film 11 may include silicon oxide, and the first upper mask film 12 may include silicon nitride, but is not limited thereto.

Subsequently, the active layer 202 may be anisotropically etched, using the mask pattern MP1 as an etching mask. Accordingly, back gate trenches BG_T extending in the first direction D1 may be formed on the active layer 202. The back gate trenches BG_T may expose the buried insulating film 201, and may be spaced apart at regular intervals in the second direction D2.

In some example embodiments, at least a part of the buried insulating films 201 may be removed, while the back gate trenches BG_T are being formed.

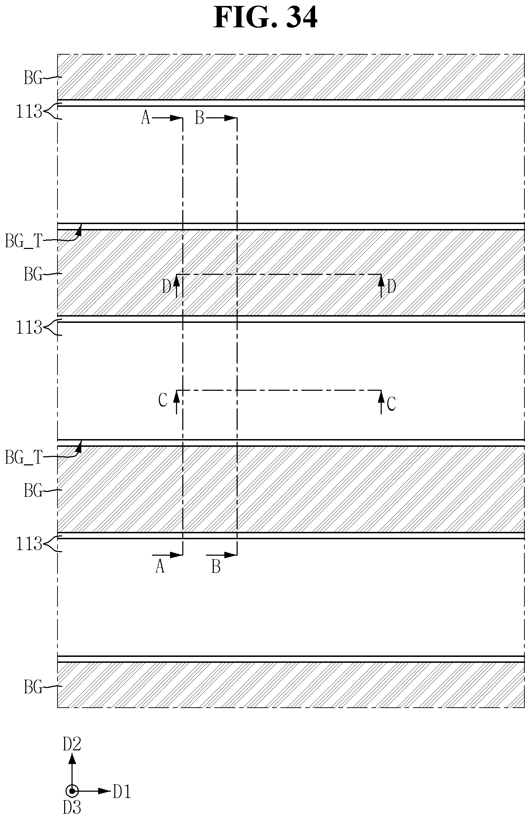

Referring to FIGS. 34 to 36, back gate insulating pattern 113 and the back gate electrodes BG may be formed inside the back gate trench BG_T.

For example, the back gate insulating pattern 113 may be formed along the side wall and bottom surface of the back gate trench BG_T and the upper surface of the mask pattern MP1. A back gate conductive film may be formed on the back gate insulating pattern 113. The back gate conductive film may fill the back gate trench BG_T. Subsequently, the back gate conductive film may be isotropically etched to form the back gate electrodes BG extending in the first direction D1. The back gate electrodes BG may partially fill the back gate trench BG_T.

Meanwhile, according to some example embodiments, a gas phase doping (GPD) process or a plasma doping (PLAD) process may be performed, before forming the back gate insulating pattern 113. Through the aforementioned process, the active layer 202 exposed by the back gate trench BG_T may be doped with impurities.

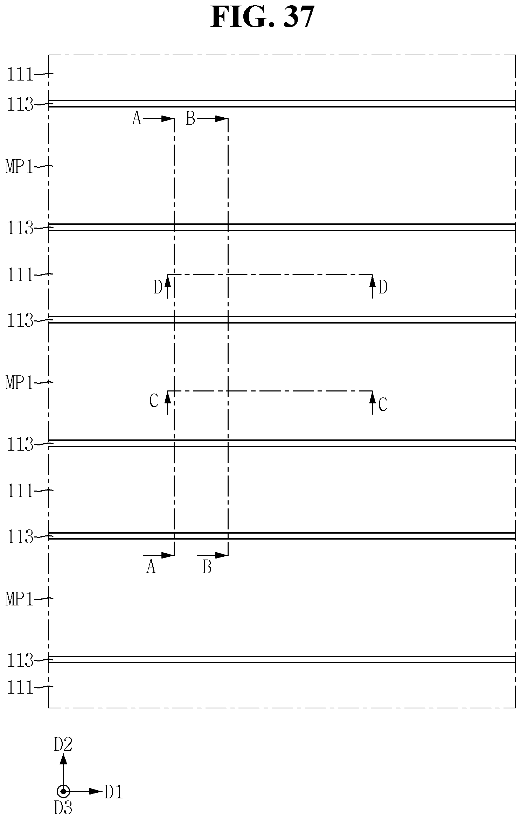

Referring to FIGS. 37 to 39, a back gate separation patterns 111 may be formed on the back gate electrode BG.

The back gate separation pattern 111 may fill the remainder of the back gate trench BG_T. When the back gate separation pattern 111 and the back gate insulating pattern 113 are formed of the same material (for example, silicon oxide), the back gate insulating pattern 113 on the upper surface of the mask pattern MP1 may be removed, while the back gate separation pattern 111 is being formed.

Meanwhile, before forming the back gate separation pattern 111, a gas phase doping (GPD) process or a plasma doping (PLAD) process may be performed. The active layer 202 may be doped with impurities through the back gate trench BG_T in which the back gate electrode BG is formed, accordingly.

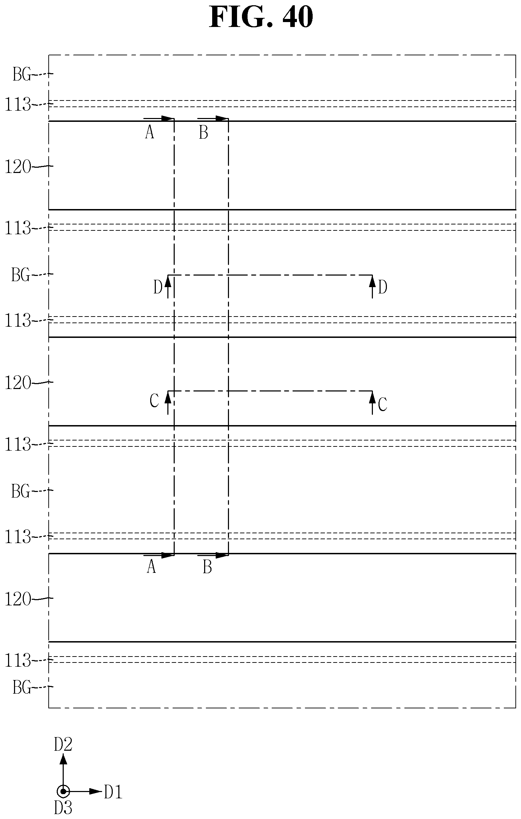

Referring to FIGS. 40 to 42, after forming the back gate separation patterns 111, the first upper mask film 12 may be removed.

The back gate separation patterns 111 may have a shape that protrudes above the upper surface of the first lower mask film 11.

Next, a spacer film 120 may be formed along the upper surface of the first lower mask film 11, the side walls of the back gate insulating patterns 113, and the upper surfaces of the back gate separation patterns 111. The spacer film 120 may be formed to have a uniform thickness. The widths of the active patterns of the vertical channel transistors may be determined depending on the deposited thickness of the spacer film 120.

The spacer film 120 may be formed of an insulating material. The spacer film 120 may include, for example, silicon oxide, silicon oxynitride, silicon nitride, silicon carbide (SiC), silicon carbon nitride film (SiCN), combinations thereof, or the like.

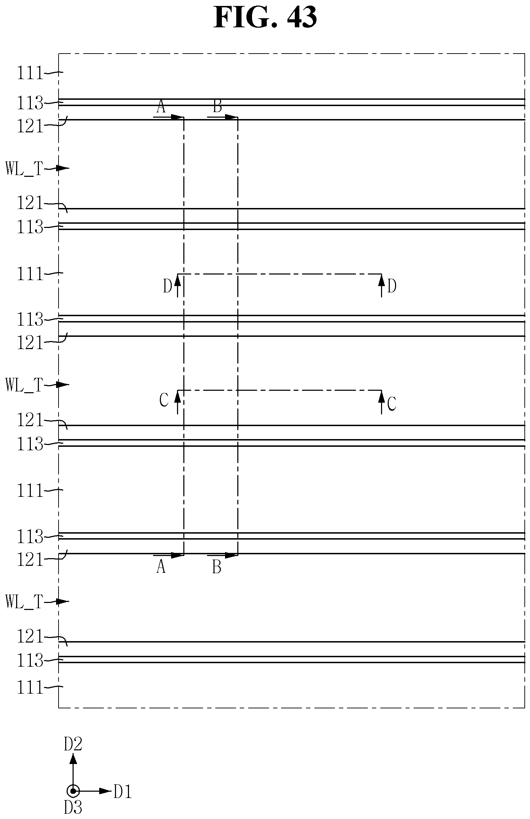

Referring to FIGS. 43 to 45, a pair of spacer patterns 121 may be formed on the side walls of the back gate insulating pattern 113, by performing an anisotropic etching process on the spacer film 120.

The anisotropic etching process may be performed on the active layer 202, by using the spacer pattern 121 as an etching mask. Accordingly, a pair of pre-active patterns PAP separated from each other may be formed on both sides of each back gate insulating pattern 113. As the pre-active patterns PAP are formed, the buried insulating film 201 may be exposed.

The pre-active patterns PAP may extend in the first direction D1 along with the back gate electrode BG. While the pre-active patterns PAP are being formed, a word line trench WL_T may be formed between the pre-active patterns PAP adjacent to each other in the second direction D2.

Referring to FIGS. 43 to 48, a sacrificial film which fills the word line trench WL_T may be formed. A pattern mask may be formed on the sacrificial film. The pattern mask may have a line form extending in the second direction D2. As another example, the pattern mask may have the line form extending in the diagonal direction with respect to the first direction D1 and the second direction D2. The sacrificial film may be etched using the pattern mask as an etching mask to form sacrificial openings inside the sacrificial film.

By etching the pre-active patterns PAP exposed to the sacrificial openings, the first active pattern AP1 and the second active pattern AP2 may be formed on both sides of the back gate electrode BG. The first active patterns AP1 may be formed on the first side wall of the back gate electrode BG to be spaced apart from each other in the first direction D1. The second active patterns AP2 may be formed on the second side wall of the back gate electrode BG to be spaced apart from each other in the first direction D1. Because the first active pattern AP1 and the second active pattern AP2 are formed, the sacrificial openings may expose a part of the back gate insulating pattern 113.

Thereafter, the sacrificial film, the pattern mask, and the spacer pattern 121 may be removed. The first lower mask film 11 may remain on the first active pattern AP1 and the second active pattern AP2. The buried insulating film 201 may be exposed.

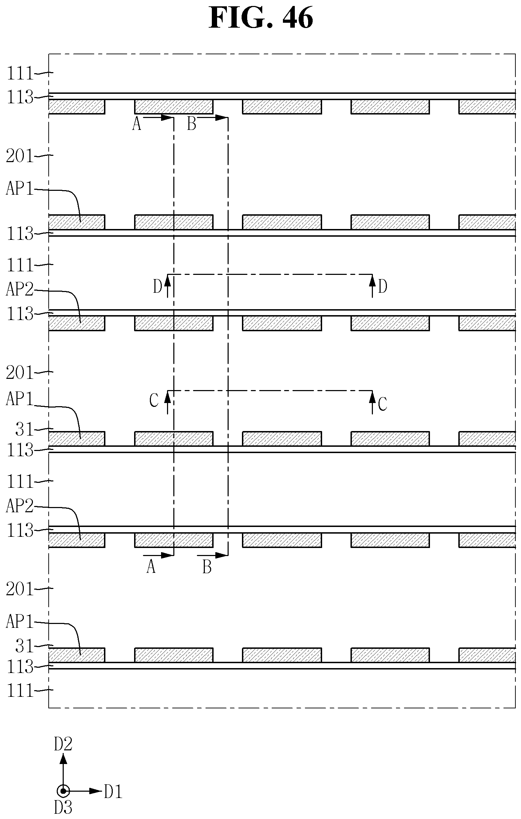

Referring to FIGS. 46 to 50, a gate shielding pattern 145 may be formed inside the word line trench WL_T.

The gate shielding pattern 145 may partially fill the word line trench WL_T. The gate shielding pattern 145 may be formed on the buried insulating film 201.

Subsequently, the gate insulating pattern GOX may be formed along the side walls of the first active pattern AP1, the side walls of the second active pattern AP2, and the upper surface of the back gate separation pattern 111. The gate insulating pattern GOX may be formed along the exposed face of the gate shielding pattern 145. The exposed face of the gate shielding pattern 145 may be an upper surface of the gate shielding pattern 145.

The gate insulating pattern GOX may be formed, but not limited to, using at least one of physical vapor deposition (PVD), thermal chemical vapor deposition (thermal CVD), low-pressure chemical vapor deposition (LP-CVD), plasma enhanced chemical vapor deposition (PE-CVD) or atomic layer deposition (ALD) techniques.

In some example embodiments, the gate shielding pattern 145 may not be formed before the gate insulating pattern GOX is formed. In these embodiments, the gate insulating pattern GOX may be located between the gate shielding pattern 145 and the back gate insulating pattern 113 (see embodiment of FIG. 15).

Subsequently, a first pre-word line WL_P1 may be formed on the gate insulating pattern GOX. The first pre-word line pattern P_WL1 may be formed along the profile of the gate insulating pattern GOX. The first pre-word line pattern P_WL1 may be formed along the side walls of the first active pattern AP1, the side walls of the second active pattern AP2, and the upper surface of the back gate separation pattern 111. The first pre-word line pattern P_WL1 may be formed along the upper surface of the gate shielding pattern 145.

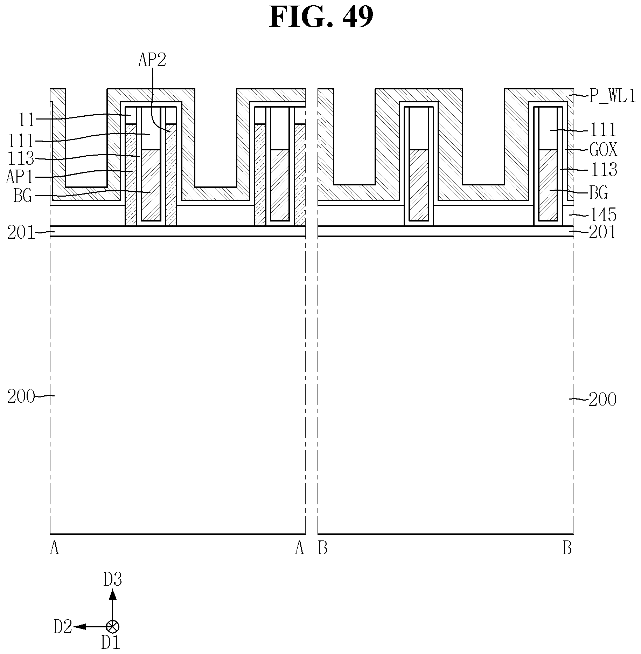

Referring to FIGS. 49 to 52, a gate separation pattern GSS may be formed on the first pre-word line pattern P_WL1.

The gate separation pattern GSS may fill the word line trench WL_T. The gate separation pattern GSS may not cover the first pre-word line pattern P_WL1 on the upper surface of the back gate separation pattern 111.

Subsequently, the first pre-word line pattern P_WL1 on the upper surface of the back gate separation pattern 111 may be removed to form a second pre-word line pattern P_WL2.

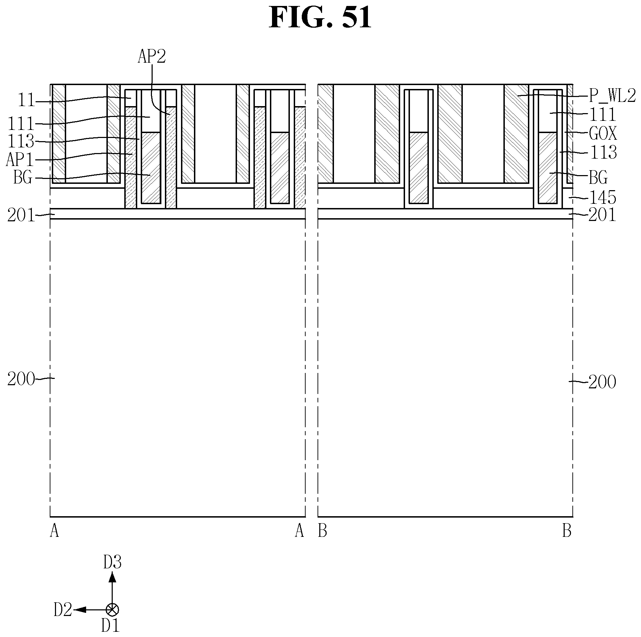

Referring to FIGS. 51 to 53, a second line pattern WL_M2 may be formed on the gate shielding pattern 145, by removing a part of the second pre-word line pattern P_WL2.

While the second line pattern WL_M2 is being formed, a first word line recess may be formed between the back gate electrode BG and the gate separation pattern GSS. A bottom surface of the first word line recess may be defined by the second line pattern WL_M2.

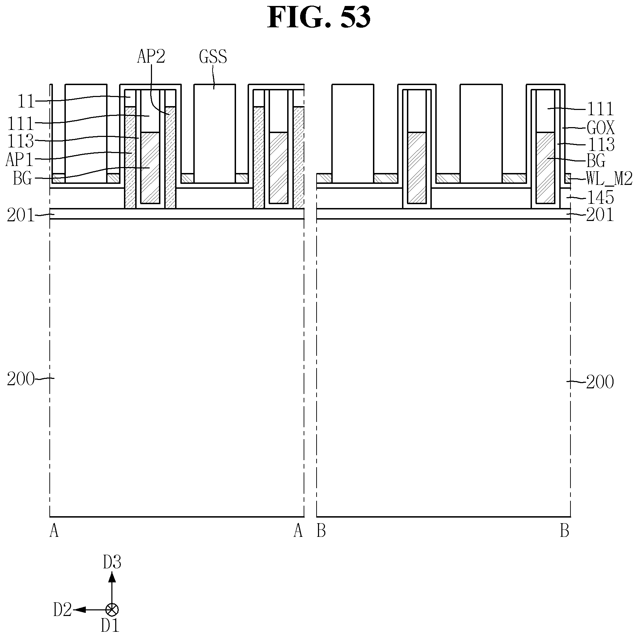

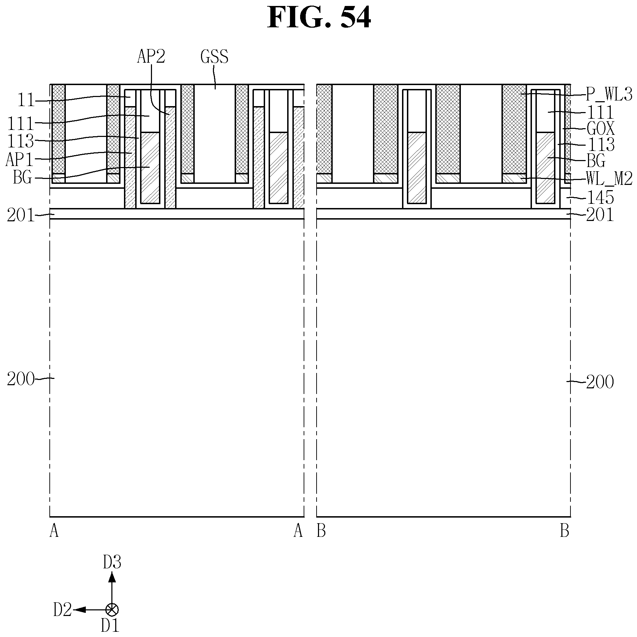

Referring to FIGS. 53 and 54, a third pre-word line pattern P_WL3 may be formed inside the first word line recess.

The third pre-word line pattern P_WL3 may fill the first word line recess.

As an example, the third pre-word line pattern P_WL3 may be formed along the side wall of the first word line recess and the bottom surface of the first word line recess. As the thickness of the third pre-word line pattern P_WL3 increases, the third pre-word line pattern P_WL3 may fill the first word line recess.

While the third pre-word line pattern P_WL3 fills the first word line recess, the third pre-word line pattern P_WL3 on the side wall of the back gate electrode BG may join with the third pre-word line pattern P_WL3 on the side wall of the gate separation pattern GSS. The third pre-word line pattern P_WL3 on one side wall of the first word line recess joins with the third pre-word line pattern P_WL3 on the other wall of the first word line recess, and a line internal interface WL_IF may be formed.

The line internal interface WL_IF may not be formed, depending on the method by which the third pre-word line pattern P_WL3 is deposited.

While the third pre-word line pattern P_WL3 is being formed, a part of the third pre-word line pattern P_WL3 may be formed on the upper surface of the back gate separation pattern 111. The third pre-word line pattern P_WL3 on the upper surface of the back gate separation pattern 111 may be removed through the etching process.

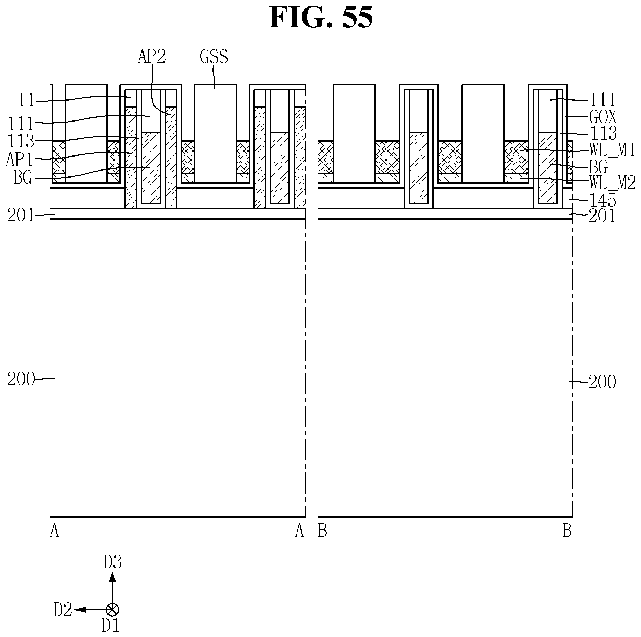

Referring to FIGS. 54 and 55, a part of the third pre-word line pattern P_WL3 may be removed to form a first line pattern WL_M1 on the second line pattern WL_M2.

While the first line pattern WL_M1 is being formed, a second word line recess may be formed between the back gate electrode BG and the gate separation pattern GSS. A bottom surface of the second word line recess may be defined by the second line pattern WL_M2.

Referring to FIGS. 55 to 58, a third line pattern WL_M3 may be formed inside the second word line recess.

The third line pattern WL_M3 may be formed in the manner similar to formation of the second line pattern WL_M2. The third line pattern WL_M3 may partially fill the second word line recess.

Accordingly, the first word line WL1 and the second word line WL2 including the first line pattern WL_M1, the second line pattern WL_M2, and the third line pattern WL_M3 may be formed on the gate shielding pattern 145.

Subsequently, a gate capping pattern 143 may be formed on the first word line WL1 and the second word line WL2. The gate capping pattern 143 may be formed on the third line pattern WL_M3.

During the formation of the gate capping pattern 143, a part of the back gate separation pattern 111 and the first lower mask film 11 may be removed. The first active pattern AP 1 and the second active pattern AP2 may be exposed, accordingly.

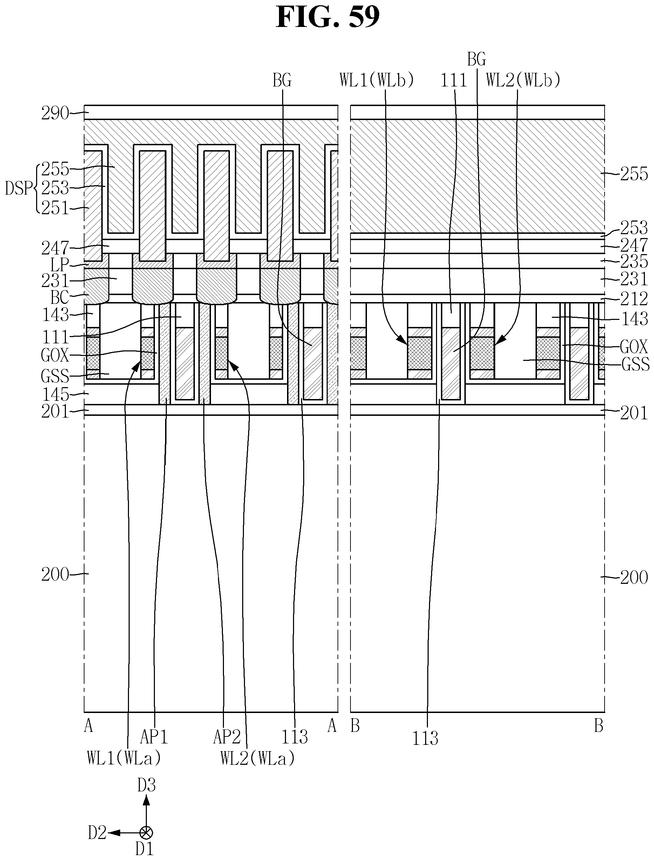

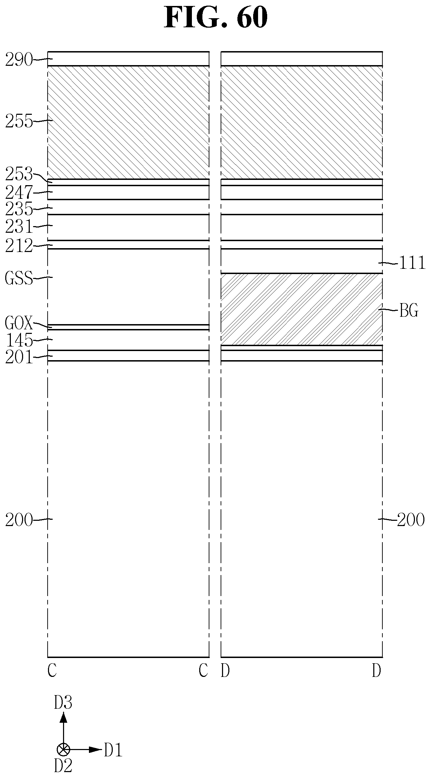

Referring to FIGS. 59 and 60, a contact hole for exposing the first active pattern AP1 and the second active pattern AP2 may be formed inside the contact etching stop film 212 and the contact interlayer insulating film 231.

The contact pattern BC may be formed inside the contact hole. The contact patterns BC may be formed on the first active pattern AP1 and the second active pattern AP2. The contact patterns BC may be connected to the first active pattern AP1 and the second active pattern AP2. Data storage patterns DSP may be formed on the contact pattern BC.

Next, a cell upper insulating film 290 may be formed on the data storage pattern DSP.

Referring to FIGS. 59 to 62, a first sub-substrate 200 on which the back gate electrodes BG, the word lines WL1 and WL2, the active patterns AP1 and AP2, and the data storage patterns DSP are formed may be bonded to the second sub-substrate 300. The second sub-substrate 300 may be bonded to (e.g. directly to) the cell upper insulating film 290.

The back gate electrodes BG, the word lines WL1 and WL2, the active patterns AP1 and AP2, and the data storage patterns DSP may be disposed between the first sub-substrate 200 and the second sub-substrate 300.

Although it is not shown, the first sub-substrate 200 and the second sub-substrate 300 may be bonded, using a bonding adhesive film.

As an example, the second sub-substrate 300 may be a semiconductor substrate. As another example, the second sub-substrate 300 may be an insulating substrate that includes an insulating material.

Subsequently, after bonding the first sub-substrate 200 and the second sub-substrate 300, a back lapping process for removing the first sub-substrate 200 may be performed.

Removal of the first sub-substrate 200 may include a process of exposing the buried insulating film 201 by sequentially performing a grinding process and a wet etching process.

Next, the buried insulating film 201 may be removed to expose the first active pattern AP1 and the second active pattern AP2. By removing the buried insulating film 201, a part of the back gate insulating pattern 113 may be exposed.

Next, the exposed back gate insulating pattern 113 may be removed. The back gate electrode BG may be exposed, accordingly.

Thereafter, an etch-back process may be performed to remove a part of the back gate electrode BG. The back gate capping pattern 115 may be formed on the recessed back gate electrode BG.

Subsequently, a bit line BL extending in the second direction D2 may be formed on the first active pattern AP1 and the second active pattern AP2. The shielding conductive pattern SL may be formed on the bit line BL. A shielding insulating capping film 175 may be formed on the shielding conductive pattern SL.

Next, a first cell lower insulating film 271 may be formed on the shielding insulating capping film 175. The second cell lower insulating film 272 may be formed on the first cell lower insulating film 271. The cell connecting wiring 281 may be formed inside the second cell lower insulating film 272. The third cell lower insulating film 273 may be formed on the second cell lower insulating film 272. The upper pad plug 282 and the upper bonding pad BP2 may be formed inside the third cell lower insulating film 273.

Next, referring to FIGS. 2 and 3, the substrate 100 on which the peri-gate structure PG, the first peri-connecting structures 242a and 242b, the second peri-connecting structures 243a and 243b, the lower bonding pad BP1, and the lower pad plug 244 are formed may be bonded to the second sub-substrate 300.

The second sub-substrate 300 and the substrate 100 may be bonded, using the bonding adhesive film 267. In some example embodiments, the second sub-substrate 300 and the substrate 100 may be bonded without the bonding adhesive film 267.

Subsequently, the second sub-substrate 300 may be removed.

Although some example embodiments of the present disclosure have been described with reference to the accompanying drawings, the present disclosure is not limited to the above example embodiments, but may be implemented in various different forms. A person skilled in the art may appreciate that the present disclosure may be practiced in other concrete forms without changing the technical concepts or essential characteristics of the present disclosure. Therefore, it should be appreciated that the example embodiments as described above is not restrictive but illustrative in all respects.

## Claims

1. A semiconductor memory device comprising:
a bit line extending in a first direction on a substrate;
an active pattern on the bit line, the active pattern including a first side wall and a second side wall that are opposite to each other in the first direction and a first surface and a second surface that are opposite to each other in a vertical direction, the first surface of the active pattern being connected to the bit line;
a word line on the first side wall of the active pattern, the word line extending in a second direction; and
a data storage pattern on the active pattern, the data storage pattern connected to the second surface of the active pattern,
wherein the word line includes a first line pattern including a first conductive material, a second line pattern including a second conductive material different from the first conductive material, and a third line pattern including a third conductive material different from the first conductive material, and
the first line pattern is between the second line pattern and the third line pattern.

2. The semiconductor memory device of claim 1,
wherein the second conductive material is identical to the third conductive material.

3. The semiconductor memory device of claim 1 or claim 2,
wherein the first line pattern is in contact with the second line pattern and the third line pattern.

4. The semiconductor memory device of claim 1 or claim 2,
wherein the word line further includes a fourth line pattern between the first line pattern and the second line pattern, and
the fourth line pattern includes a fourth conductive material different from the first conductive material and the second conductive material.

5. The semiconductor memory device of claim 4,
wherein the word line further includes a fifth line pattern between the first line pattern and the third line pattern, and
the fifth line pattern includes a fifth conductive material different from the first conductive material and the third conductive material.

6. The semiconductor memory device of any preceding claim,
wherein at least one of the first line pattern, the second line pattern, or the third line pattern includes an internal interface extending in the vertical direction.

7. The semiconductor memory device of any preceding claim, further comprising:
a back gate electrode on the second side wall of the active pattern, the back gate electrode extending in the second direction,
wherein the active pattern is between the back gate electrode and the word line.

8. The semiconductor memory device of claim 7,
wherein the back gate electrode includes a plurality of electrode patterns stacked in the vertical direction.

9. The semiconductor memory device of any preceding claim, further comprising:
a shielding conductive pattern on the substrate,
wherein the shielding conductive pattern includes a shielding conductive plate, and a plurality of shielding conductive line patterns protruding from the shielding conductive plate,
each of the plurality of shielding conductive line patterns extends in the first direction, and
the bit line is between shielding conductive line patterns adjacent to each other in the second direction.

10. The semiconductor memory device of any of claims 1-8, further comprising:
a shielding conductive pattern adjacent to the bit line in the second direction, the shielding conductive pattern extending in the first direction,
wherein the bit line includes an upper surface and a bottom surface that are opposite to each other in the vertical direction,
the upper surface of the bit line looks at the active pattern, and
the shielding conductive pattern is absent on the bottom surface of the bit line.

11. A semiconductor memory device comprising:
a bit line extending in a first direction on a substrate;
a word line on the bit line, the word line extending in a second direction;
a back gate electrode on the bit line, the back gate electrode extending in the second direction, the back gate being spaced apart from the word line in the first direction;
an active pattern between the word line and the back gate electrode; and
a data storage pattern on the active pattern, the data storage pattern being connected to the active pattern,
wherein the word line includes a first line pattern and a second line pattern stacked in a vertical direction,
the back gate electrode includes a first electrode pattern and a second electrode pattern stacked in the vertical direction,
the first line pattern includes a conductive material different from the second line pattern, and
the first electrode pattern includes a conductive material different from the second electrode pattern.

12. The semiconductor memory device of claim 11,
wherein the word line further includes a third line pattern including a conductive material different from the first line pattern, and
the first line pattern is between the second line pattern and the third line pattern.

13. The semiconductor memory device of claim 11 or claim 12,
wherein the back gate electrode further includes a third electrode pattern including a conductive material different from the first electrode pattern, and
the first electrode pattern is between the second electrode pattern and the third electrode pattern.

14. The semiconductor memory device of any of claims 11-13,
wherein one of the first line pattern or the second line pattern includes an internal interface extending in the vertical direction.

15. A semiconductor memory device according to any preceding claim, the comprising:
a peri-gate structure on the substrate;
a first bonding pad connected to the peri-gate structure;
a second bonding pad on the first bonding pad, the second bonding pad being in contact with the first bonding pad, wherein the bit line is on the second bonding pad; and
a shielding conductive pattern including a plurality of shielding conductive line patterns on the second bonding pad, the shielding conductive pattern extending in the first direction to be adjacent to the bit line,
wherein the word line is a first word line, the first word line being on the bit line and the shielding conductive pattern,
wherein the active pattern is a first active pattern,
wherein the semiconductor memory device further comprises:
a second word line on the bit line and the shielding conductive pattern, the second word line extending in the second direction, the second word line being spaced apart from the first word line in the first direction;
a back gate electrode between the first word line and the second word line, the back gate electrode extending in the second direction; and
a second active pattern on the bit line and between the first word line and the back gate electrode,
wherein the first active pattern is between the first word line and the back gate electrode,
wherein the data storage pattern is connected to the first active pattern and the second active pattern, and
wherein each of the first word line and the second word line includes a first line pattern including a first conductive material, a second line pattern including a second conductive material different from the first conductive material, and a third line pattern including a third conductive material different from the first conductive material.
